(19) Europäisches Patentamt
European Patent Office
Office européen des brevets

(11) **EP 4 738 872 A1**

(12) **EUROPEAN PATENT APPLICATION**
published in accordance with Art. 153(4) EPC

(43) Date of publication:
**06.05.2026 Bulletin 2026/19**

(21) Application number: **24832070.7**

(22) Date of filing: **28.06.2024**

(51) International Patent Classification (IPC):
**H04N 25/773** (2023.01)   **H04N 25/70** (2023.01)

(52) Cooperative Patent Classification (CPC):
**H04N 25/773; H04N 25/70**

(86) International application number:
**PCT/JP2024/023448**

(87) International publication number:
**WO 2025/005212 (02.01.2025 Gazette 2025/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.06.2023   JP 2023108681**
**26.06.2024   JP 2024102830**

(71) Applicant: **Canon Kabushiki Kaisha**
**Tokyo, 146-8501 (JP)**

(72) Inventors:
• **SEKINE, Hiroshi**
**Tokyo 146-8501 (JP)**
• **MORIMOTO, Kazuhiro**
**Tokyo 146-8501 (JP)**
• **ISODA, Naoki**
**Tokyo 146-8501 (JP)**

(74) Representative: **Canon Europe Limited**
**European Intellectual Property Group**
**4 Roundwood Avenue**
**Stockley Park**
**Uxbridge UB11 1AF (GB)**

(54) **PHOTOELECTRIC CONVERSION DEVICE AND PHOTOELECTRIC CONVERSION SYSTEM HAVING PHOTOELECTRIC CONVERSION DEVICE**

(57)     The present invention has an exposure control unit that generates a signal defining a plurality of second exposure periods which are included in a first exposure period corresponding to one frame and which are each shorter than the first exposure period. The present invention has a timing generation unit that generates a pulse signal defining time information within each of the second exposure periods. The present invention has a measurement unit that measures a number of the pulse signal from an initial detection of a photon in each of the second exposure periods, based on the pulse signal generated by the timing generation unit.

FIG. 1

EP 4 738 872 A1

## Description

Technical Field

The present invention relates to a photoelectric conversion device and a photoelectric conversion system including a photoelectric conversion device.

Background Art

PTL 1 discloses a configuration for measuring the time until a counter saturates for each pixel and estimating light intensity by extrapolation from the time and the count value. This configuration allows for expansion of the dynamic range.

Citation List

Patent Literature

PTL 1: International Publication No. WO 2020/179928

Summary of Invention

Technical Problem

According to the configuration in PTL 1, the counter stops once saturated, which results in missing signal information after the counter stops. This could result in, for example, artifacts when shooting a moving subject, or brightness variations when shooting a flickering light source.

Solution to Problem

The present invention provides a photoelectric conversion device including a photoelectric conversion element that receives photons, an exposure control unit that generates a signal defining a plurality of second exposure periods which are included in a first exposure period corresponding to one frame and which are each shorter than the first exposure period, a timing generation unit that generates a pulse signal defining time information within each of the second exposure periods, and a measurement unit that measures a number of the pulse signal from an initial detection of a photon in each of the second exposure periods, based on the pulse signal generated by the timing generation unit.

Advantageous Effects of Invention

According to the present invention, it is possible to acquire more signal information compared to PTL 1.

Brief Description of Drawings

[Fig. 1] Fig. 1 is a diagram illustrating an example of the configuration of a pixel circuit.
[Fig. 2A] Fig. 2A is a diagram for explaining the relationship between a detection time and a number of incident photons.
[Fig. 2B] Fig. 2B is a diagram for explaining the relationship between a detection time and a number of incident photons.
[Fig. 3A] Fig. 3A is a diagram for explaining the relationship between a detection time and a number of incident photons.
[Fig. 3B] Fig. 3B is a diagram for explaining the relationship between a detection time and a number of incident photons.
[Fig. 3C] Fig. 3C is a diagram for explaining the relationship between a detection time and a number of incident photons.
[Fig. 4] Fig. 4 is a diagram for explaining photon detection probability.
[Fig. 5A] Fig. 5A is a diagram for explaining an expected value of a number of incident photons.
[Fig. 5B] Fig. 5B is a diagram for explaining input/output characteristics.
[Fig. 5C] Fig. 5C is a diagram for explaining input/output characteristics.
[Fig. 6] Fig. 6 is a diagram for explaining a photoelectric conversion device according to a first embodiment.
[Fig. 7] Fig. 7 is a diagram for explaining a photoelectric conversion device according to the first embodiment.
[Fig. 8] Fig. 8 is a diagram for explaining a photoelectric conversion device according to the first embodiment.
[Fig. 9] Fig. 9 is a diagram for explaining a photoelectric conversion device according to the first embodiment.
[Fig. 10A] Fig. 10A is a diagram for explaining a pixel circuit of, and the driving of, a photoelectric conversion device according to the first embodiment.
[Fig. 10B] Fig. 10B is a diagram for explaining a pixel circuit of, and the driving of, a photoelectric conversion device according to the first embodiment.
[Fig. 10C] Fig. 10C is a diagram for explaining a pixel circuit of, and the driving of, a photoelectric conversion device according to the first embodiment.
[Fig. 11] Fig. 11 is a diagram for explaining an operating sequence of a photoelectric conversion device according to the first embodiment.
[Fig. 12] Fig. 12 is a diagram for explaining cases where a clock signal defining time information is equally spaced and unequally spaced.
[Fig. 13A] Fig. 13A is a diagram for explaining a clock signal defining time information, and input/output characteristics.
[Fig. 13B] Fig. 13B is a diagram for explaining a clock signal defining time information, and input/output characteristics.

[Fig. 14A] Fig. 14A is a diagram for explaining a pixel circuit of a photoelectric conversion device according to a second embodiment.

[Fig. 14B] Fig. 14B is a diagram for explaining a pixel circuit of a photoelectric conversion device according to the second embodiment.

[Fig. 15] Fig. 15 is a diagram for explaining an operating sequence of a photoelectric conversion device according to the second embodiment.

[Fig. 16] Fig. 16 is a diagram for explaining a pixel circuit of a photoelectric conversion device according to a third embodiment.

[Fig. 17] Fig. 17 is a diagram for explaining an operating sequence of a photoelectric conversion device according to the third embodiment.

[Fig. 18] Fig. 18 is a diagram for explaining an effect of a photoelectric conversion device according to the third embodiment.

[Fig. 19] Fig. 19 is a diagram for explaining a pixel circuit of a photoelectric conversion device according to a fourth embodiment.

[Fig. 20] Fig. 20 is a diagram for explaining a pixel circuit of a photoelectric conversion device according to the fourth embodiment.

[Fig. 21A] Fig. 21A is a diagram for explaining an operating sequence of a photoelectric conversion device according to the fourth embodiment.

[Fig. 21B] Fig. 21B is a diagram for explaining an operating sequence of a photoelectric conversion device according to the fourth embodiment.

[Fig. 22A] Fig. 22A is a diagram for explaining an operating sequence of a photoelectric conversion device according to the fourth embodiment.

[Fig. 22B] Fig. 22B is a diagram for explaining an operating sequence of a photoelectric conversion device according to the fourth embodiment.

[Fig. 23] Fig. 23 is a diagram for explaining a photoelectric conversion device according to a fifth embodiment.

[Fig. 24] Fig. 24 is a diagram for explaining a pixel circuit of a photoelectric conversion device according to the fifth embodiment.

[Fig. 25] Fig. 25 is a diagram for explaining a signal processing block of a photoelectric conversion device according to a sixth embodiment.

[Fig. 26A] Fig. 26A is a schematic diagram according to a seventh embodiment.

[Fig. 26B] Fig. 26B is a schematic diagram according to the seventh embodiment.

[Fig. 27] Fig. 27 is a functional block diagram of a photoelectric conversion system according to an eighth embodiment.

[Fig. 28A] Fig. 28A is a functional block diagram of a photoelectric conversion system according to a ninth embodiment.

[Fig. 28B] Fig. 28B is a functional block diagram of a photoelectric conversion system according to the ninth embodiment.

[Fig. 29] Fig. 29 is a functional block diagram of a photoelectric conversion system according to a 10th embodiment.

[Fig. 30] Fig. 30 is a functional block diagram of a photoelectric conversion system according to an 11th embodiment.

[Fig. 31A] Fig. 31A is a functional block diagram of a photoelectric conversion system according to a 12th embodiment.

[Fig. 31B] Fig. 31B is a functional block diagram of a photoelectric conversion system according to the 12th embodiment.

Description of Embodiments

The forms indicated in the following are intended to embody the technical concepts of the present invention, and do not limit the present invention. The sizes and positional relationships of members illustrated in each of the drawings may be exaggerated for clarity. In the following description, like components are denoted with like numerals, and a description may be omitted.

In the following description, terms indicating specific directions and/or positions (for example, "up", "down", "right", "left", and other terms including these terms) are used as necessary. The use of these terms is to facilitate understanding of embodiments with reference to the drawings, and the technical scope of the present invention is not to be limited by the meanings of these terms.

In this specification, plan view means viewing from a direction perpendicular to the main surface of a semiconductor layer, and is synonymous with top view. Also, cross-sectional view means viewing from a direction perpendicular to a plane in a direction perpendicular to the main surface of a semiconductor layer.

In the following description, the anode of a photodiode (PD) is set to a fixed potential, and a signal is extracted from the cathode side. Consequently, a semiconductor region of a first conductivity type having many carriers of charge of the same polarity as a signal charge refers to an n-type semiconductor region, while a semiconductor region of a second conductivity type having many carriers of charge of a different polarity from the signal charge refers to a p-type semiconductor region. The cathode of a PD may be set to a fixed potential, and a signal may be extracted from the anode side. In this case, a semiconductor region of a first conductivity type having many carriers of charge of the same polarity as a signal charge refers to a p-type semiconductor region, while a semiconductor region of a second conductivity type having many carriers of charge of a different polarity from the signal charge refers to an n-type semiconductor region. The following describes a case where one of the nodes of a PD is set to a fixed potential, but a configuration in which both nodes have fluctuating potentials may also be adopted.

(Basic Configuration)

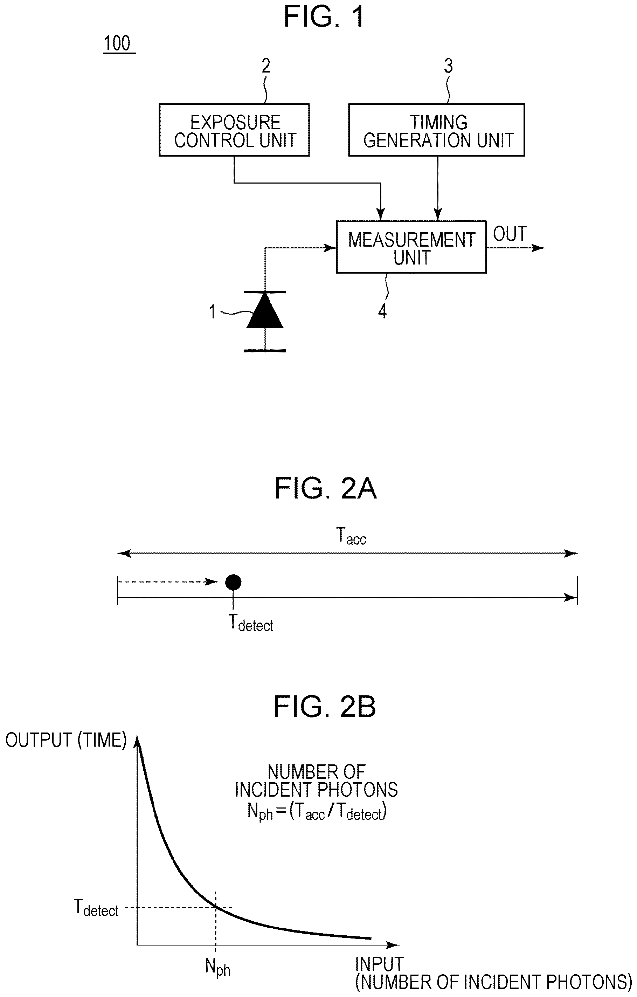

Fig. 1 is a diagram illustrating a schematic configuration of a photoelectric conversion device according to the embodiments. A photoelectric conversion device 100 includes a photoelectric conversion element 1, an exposure control unit 2, a timing generation unit 3, and a measurement unit 4.

The photoelectric conversion element 1 detects and converts incident photons into an electrical signal. The photoelectric conversion element 1 may be a linear-mode avalanche photodiode (APD) operating around a breakdown voltage, or a single-photon avalanche diode (SPAD) operating in Geiger mode.

The exposure control unit 2 generates a signal defining an exposure period (first exposure period) corresponding to one frame. The "exposure period corresponding to one frame" may also be referred to as the "1-frame period". The exposure control unit 2 also generates a signal defining an exposure period (second exposure period) corresponding to each of multiple subframes included in the exposure period corresponding to one frame. The "exposure period corresponding to a subframe" may also be referred to as the "subframe period".

The timing generation unit 3 generates a pulse signal for defining time information within the subframe period.

The measurement unit 4 accepts input of a signal from the photoelectric conversion element 1, a control signal from the exposure control unit 2, and a control signal from the timing generation unit 3. Based on these signals, the measurement unit 4 measures a numerical value corresponding to the detection time from the beginning of the subframe period until a photon is initially detected. The measurement unit may use a typical TDC circuit as a circuit for measuring time, or take measurements according to some other method.

Fig. 2A is a diagram illustrating an exposure period and a detection time, and Fig. 2B is a diagram illustrating the relationship between the detection time and the number of incident photons.

Let $T_{aac}$ be the exposure period and let $T_{detect}$ be the time from the beginning of the exposure period to the time at which a photon is detected, in which case the number $N_{ph}$ of incident photos that are incident during the exposure period is represented by $N_{ph} = (T_{aac} / T_{detect})$. Consequently, if the exposure period and the detection period are known, it is possible to also estimate the number of incident photons. In other words, without counting the actual number of incident photons, the number of incident photons that are incident during the exposure period can be known, and thus imaging is possible.

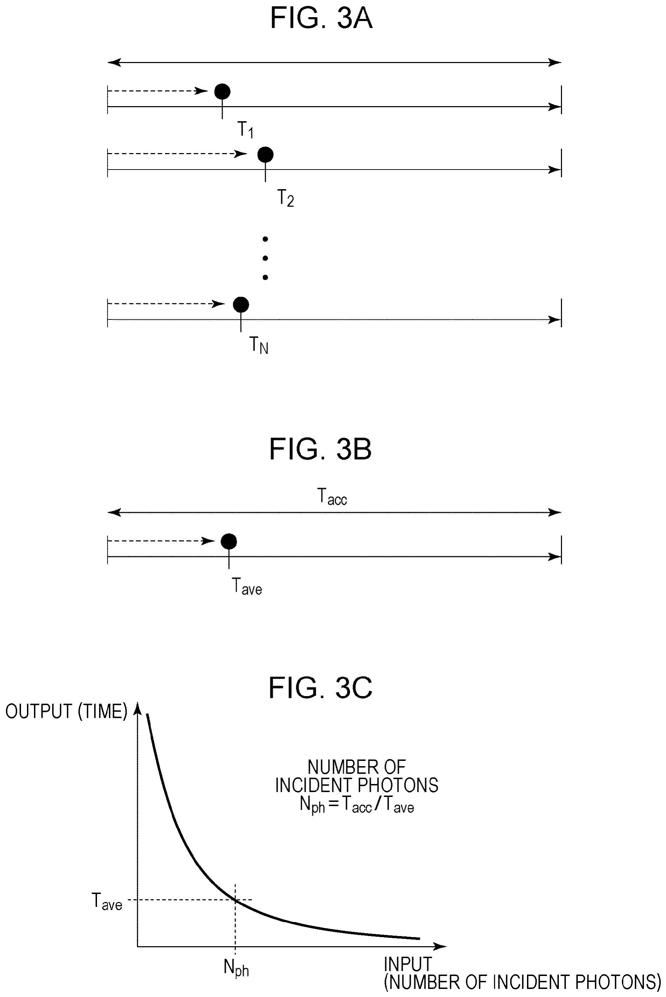

Figs. 3A and 3B are diagrams illustrating a case of performing the exposure illustrated in Fig. 2A multiple times. The measurement period for each exposure is called the subframe period, and the subframe periods are represented as repeating N times. The 1-frame period is the sum from subframe 1 to subframe N. Let $T_{ave}$ be the average time at which a photon is detected in the subframes during the 1-frame period, in which case the number $N_{ph}$ of incident photons during a single frame can be estimated as $N_{ph} = (T_{aac} / T_{ave}) \times N$. Fig. 3C is a diagram illustrating the correspondence relation between the average detection time and the number of incident photons.

In Fig. 3B, the description is focused on the average time of photon detection, but it is possible to estimate the number of incident photons even from the integrated time of photon detection. In addition, averaging and integrating processing may be performed within the photoelectric conversion device, or a signal for each subframe may be outputted externally to the photoelectric conversion device and processed by an external processing circuit.

The above relation between the number of incident photons and the detection time is suitable in cases where the smallest unit of detection time is sufficiently smaller than the photon detection time, but may be affected in cases where the smallest unit of detection time and the photon detection time are comparable. For example, even within the smallest unit of detection time, the expected number of incident photons may vary depending on the timings at which photons are originally detected, and thus error may occur in the above relation. A situation where such error is non-negligible is described as being affected by the detection times being discrete.

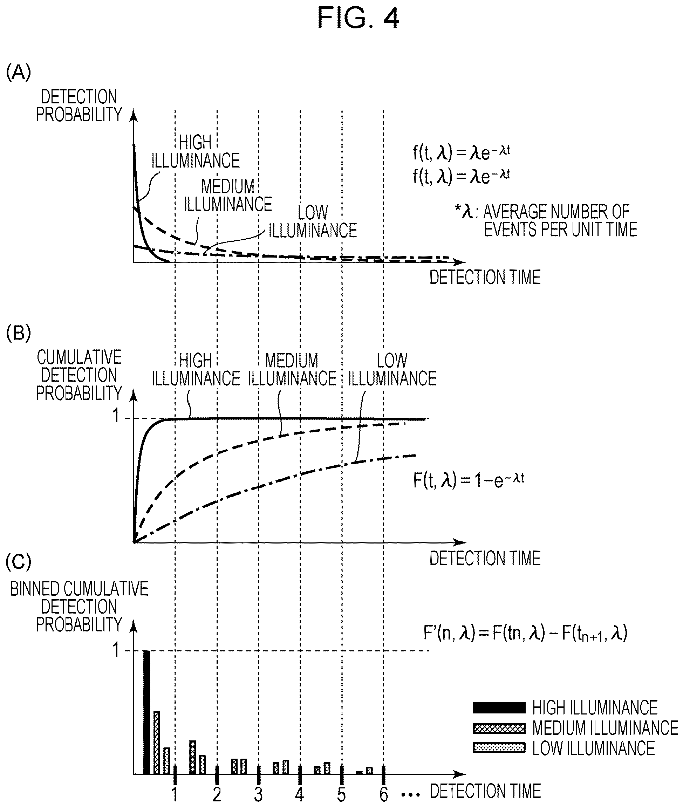

In Fig. 4, estimation of the number of photons in the case where the detection times are discrete is explained. Fig. 4 is a conceptual diagram for explaining photon detection probability. Let the detection times be 1, 2, and so on, in which case the probability that a photon will be detected at a given time is known to obey an exponential distribution ($f(t, \lambda) = \lambda e^{-\lambda t}$, where $\lambda$ is the number of events per unit time). In this specification, $\lambda$ is a value determined by the number $N_{ph}$ of incident photons, the exposure time, and the unit time (smallest unit of detection time). Specifically, $\lambda$ is (number of incident photons / exposure time) $\times$ (unit time). For example, if the number of incident photons is 1, the exposure time is 1000, and the unit time is 1, then $\lambda$ becomes (1 / 1000) $\times$ 1, which is equal to 0.001. Obeying this exponential distribution, the photon detection probability can be represented by the graph illustrated in Fig. 4(A), in which detection time is plotted on the horizontal axis. The solid line, the dashed line, and the chain line indicate high illuminance, medium illuminance, and low illuminance, respectively. Also, the binned cumulative detection probability is expressed by $F(t, A) = 1 - e^{-\lambda t}$, and can be represented by the graph illustrated in Fig. 4(B). Furthermore, the binned cumulative detection probability, in which the detection probability is accumulated in discrete detection bins (0 to 1, 1 to 2, and so on), can be represented by $F'(n, \lambda) = F(t_n, \lambda) - F(t_{n+1}, \lambda)$, and can be represented by the graph illustrated in Fig. 4(C).

By performing such calculations, the photon detection probability in each detection bin can be obtained. The sum (expected value E) of the product of the binned cumulative detection probability and the corresponding detection time can be obtained as:

[Math. 1]

$$E(\lambda) = \sum_{i=0}^{n} t_i \cdot F'(i, \lambda)$$

The expected value E corresponds to $T_{ave}$ illustrated in Fig. 3B. From the above calculations, it is possible to estimate the number $N_{ph}$ of incident photons from the expected value E, even if the detection times have become discrete.

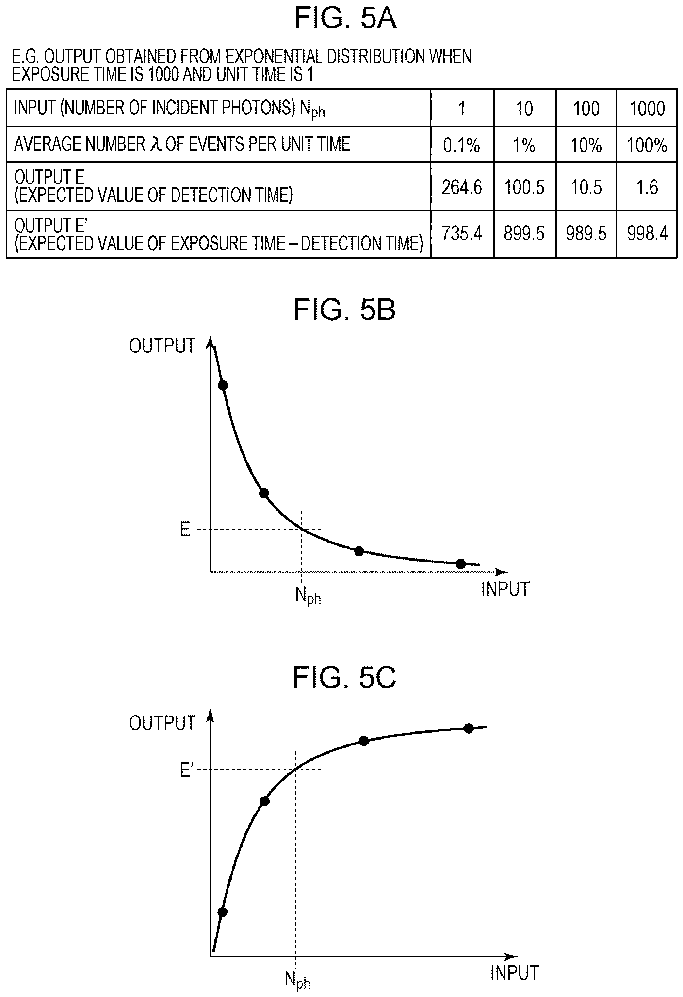

Fig. 5A illustrates a specific example of expected values for numbers of incident photons. The output E (expected value of detection time) and the output E' (expected value of exposure time - detection time) obtained when the input (number of incident photons) is changed to 1, 10, 100, and 1000 when the exposure period is 1000 and the unit time is 1 are illustrated.

Also, Figs. 5B and 5C illustrate graphs of input/output characteristics pertaining to the output E and the output E'. The output E makes a curve such that the larger the number $N_{ph}$ of incident photons, the smaller the output E. On the other hand, the output E' makes a curve such that the larger the number $N_{ph}$ of incident photons, the larger the output E.

In imaging devices, it is typical for signals to be outputted such that the larger the input, namely the number of incident photons, the larger the output. For this reason, when downstream signal processing is considered, it is preferable to output the output E' rather than the output E.

According to this configuration, the number of incident photons during the exposure period can be estimated from the photon detection timings, making it possible to expand the dynamic range beyond the number of detected photons. Moreover, the length of the subframe period can be set by the photon exposure control unit, making it possible to adjust the exposure so that the counter does not saturate during the 1-frame period. For this reason, stopping of the counter during the 1-frame period can be avoided to prevent loss of signal information, while also ensuring dynamic range.

Note that if the technical concepts described above are used, an additional configuration to stop the counter during the 1-frame period may also be adopted.

The following describes embodiments.

(First Embodiment)

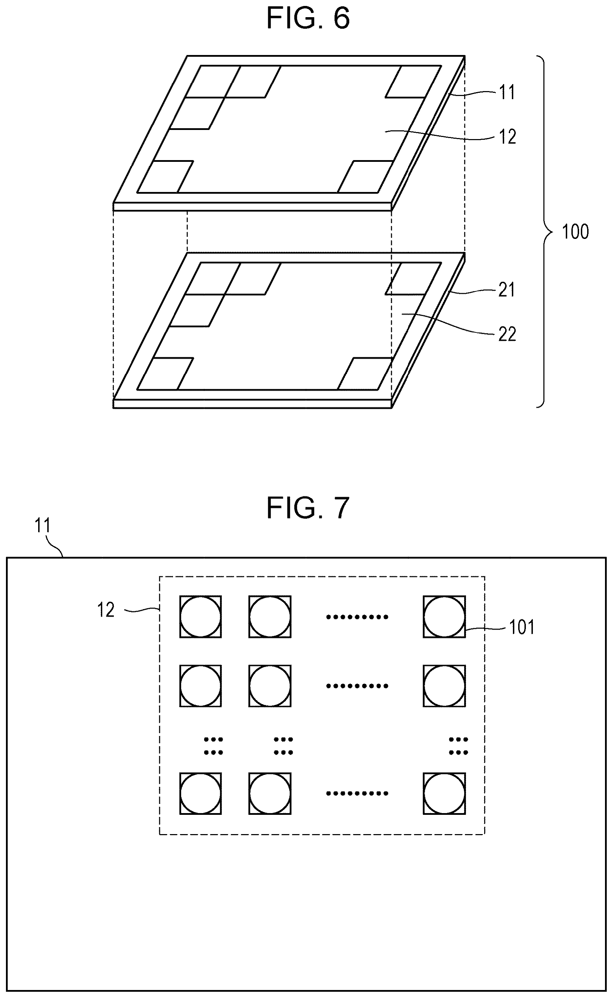

Fig. 6 is a diagram illustrating a configuration of a photoelectric conversion device 100 according to the present embodiment. The photoelectric conversion device 100 is formed by the stacking and electrical connection of two boards, namely a sensor board 11 (first board) and a circuit board 21 (second board). The sensor board 11 has multiple photoelectric conversion elements 1. The circuit board 21 has the circuitry of signal processing units 103. In the following, the sensor board 11 and the circuit board 21 are described as diced chips, but are not limited to chips. For example, each board may also be a wafer. Also, the boards may be diced after being stacked in a wafer state, or may be diced into chips after which the chips are stacked and bonded.

A pixel region 12 is laid out on the sensor board 11, and a circuit region 22 that processes signals detected in the pixel region 12 is laid out on the circuit board 21.

Fig. 7 is a diagram illustrating an example of the layout of the sensor board 11. Pixels 101 each having a photoelectric conversion element 1 that includes an avalanche photodiode (APD) are arrayed two-dimensionally in plan view to form the pixel region 12.

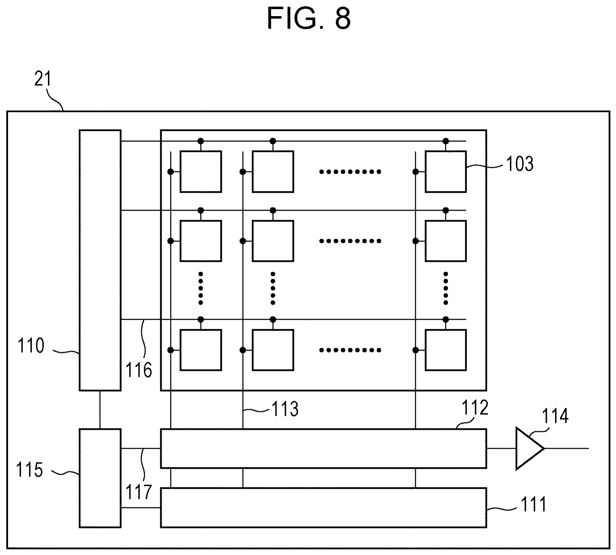

Fig. 8 is a configuration diagram of the circuit board 21. Signal processing units 103 that process charges photoelectrically converted by the photoelectric conversion elements 1, a column circuit 112, a control pulse generation unit 115, a horizontal scan circuit unit 111, signal lines 113, a vertical scan circuit unit 110, control lines 116, and control lines 117 are included.

Each of the pixels 101 having the photoelectric conversion element 1 in Fig. 7 is electrically connected to a corresponding signal processing unit 103 in Fig. 8 via connection wiring provided for each pixel. The pixel 101 and the signal processing unit 103 may also be referred to as a pixel circuit.

The vertical scan circuit unit 110 in Fig. 8 receives a control pulse supplied from the control pulse generation unit 115, and supplies the control pulse to each pixel. Logic circuits such as a shift register and an address decoder are used in the vertical scan circuit unit 110. A signal outputted from the photoelectric conversion element 1 is processed by the signal processing unit 103.

The signal processing unit 103 is provided with a counter, memory, and/or the like, and a digital value is held in the memory.

The horizontal scan circuit unit 111 inputs control pulses into the signal processing units 103 to select each column sequentially to read out a signal from the memory of each pixel in which a digital signal is held.

For each selected column, a signal from the signal processing unit 103 of the pixel selected by the vertical scan circuit unit 110 is outputted to a corresponding signal line 113.

The signal outputted to the signal line 113 is outputted, via an output circuit 114, to a recording unit or a signal processing unit external to the photoelectric conversion device 100.

In Fig. 7, the photoelectric conversion elements in the pixel region may also be laid out one-dimensionally. It is possible to obtain the effects of the present embodiment even if there is only one pixel, and thus the present embodiment also includes the case where there is only one pixel. The functions of the signal processing unit do not necessarily need to be provided one at a time with respect to all photoelectric conversion elements, and for example, one signal processing unit may be shared by multiple photoelectric conversion elements, and signal processing may be performed sequentially.

As illustrated in Figs. 7 and 8, multiple signal processing units 103 are laid out in a region that overlaps the pixel region 12 in plan view. The vertical scan circuit unit 110, the horizontal scan circuit unit 111, the column circuit 112, the output circuit 114, and the control pulse generation unit 115 are laid out so as to overlap between the edges of the sensor board 11 and the edges of the pixel region 12 in plan view. In other words, the sensor board 11 has the pixel region 12 and a non-pixel region laid out around the pixel region 12, and the vertical scan circuit unit 110, the horizontal scan circuit unit 111, the column circuit 112, the output circuit 114, and the control pulse generation unit 115 are laid out in a region that overlaps the non-pixel region in plan view.

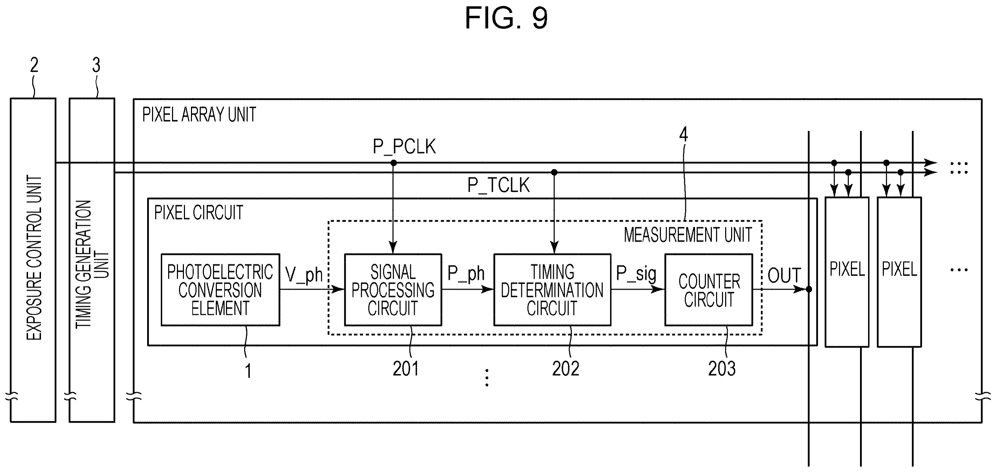

Fig. 9 is an example of a block configuration of a pixel array, the timing generation unit, and the measurement unit. The exposure control unit 2 and the timing generation unit 3 may be included in the vertical scan circuit unit 110 and/or the control pulse generation unit 115 illustrated in Fig. 8. The photoelectric conversion element 1 and the measurement unit 4 are included in the pixel circuit.

The measurement unit 4 is made up of a signal processing circuit 201, a timing determination circuit 202, and a counter circuit 203. The signal processing circuit 201 is, for example, a waveform shaping circuit, or a resistor and/or switch provided between the voltage to be applied to the photoelectric conversion element and the photoelectric conversion element. The signal processing unit 103 illustrated in Fig. 8 corresponds to the measurement unit 4 (signal processing circuit 201, timing determination circuit 202, counter circuit 203) illustrated in Fig. 9.

A pulse signal referred to as P_PCLK is outputted from the exposure control unit 2 and inputted into the signal processing circuit 201. A pulse signal referred to as P_TCLK is outputted from the timing generation unit 3 and inputted into the timing determination circuit 202.

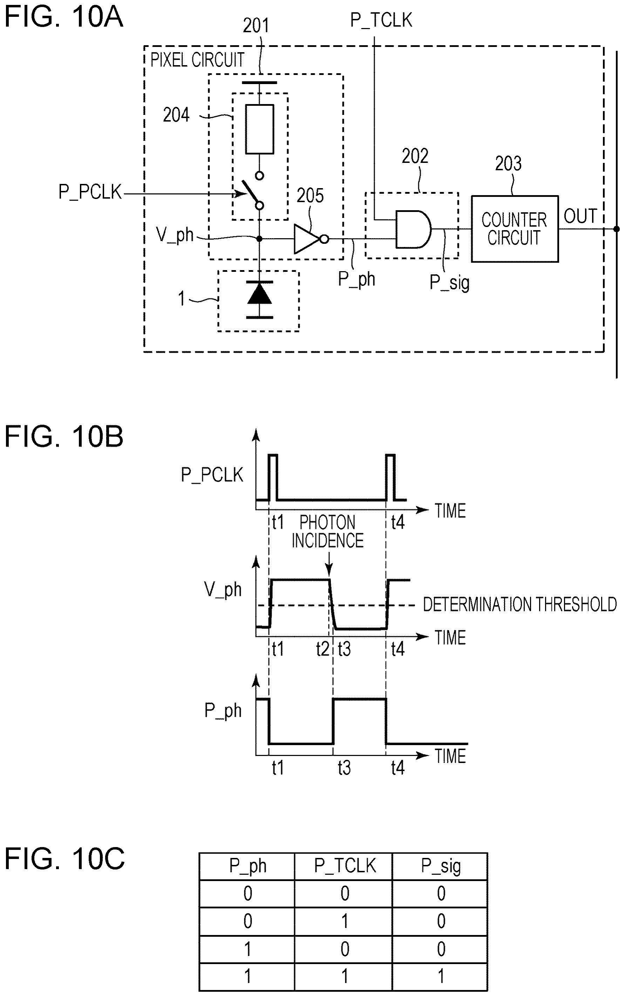

Fig. 10A is an example of the pixel circuit configuration. The photoelectric conversion element 1 is an APD, and generates charge pairs in accordance with incident light through photoelectric conversion. A voltage VL (first voltage) is supplied to the anode of the photoelectric conversion element 1. Also, a voltage VH (second voltage), which is higher than the voltage VL supplied to the anode, is supplied to the cathode of the photoelectric conversion element 1. A reverse bias voltage (voltage at or above the breakdown voltage) is supplied to the anode and the cathode to make the photoelectric conversion element 1 operate such that avalanche multiplication occurs. By achieving a state in which such a voltage is supplied, a charge generated in response to incident light undergoes avalanche multiplication and an avalanche current is generated.

In the case where a reverse bias voltage is supplied, there is Geiger mode, in which the photoelectric conversion element is operated such that the potential difference between the anode and the cathode is greater than the breakdown voltage, and linear mode, in which the photoelectric conversion element is operated such that the potential difference between the anode and the cathode is in the vicinity of or equal to or below the breakdown voltage. An APD operated in Geiger mode is called a SPAD. For example, the voltage VL (first voltage) is -30 V and the voltage VH (second voltage) is 1 V. The APD may be operated in linear mode or Geiger mode.

The signal processing circuit 201 has a quenching element 204 and a waveform shaping circuit 205. The quenching element 204 is connected to a power supply that supplies the voltage VH and the photoelectric conversion element 1. The quenching element 204 functions as a load circuit (quenching circuit) during signal multiplication by avalanche multiplication, and works to suppress the voltage supplied to the photoelectric conversion element 1 to suppress avalanche multiplication (quenching operation). Also, the quenching element 204 works to restore the voltage supplied to the photoelectric conversion element 1 to the voltage VH (recharge operation) by passing a current corresponding to the voltage drop incurred during the quenching operation. Fig. 10A illustrates an example in which a switch such as a transistor is disposed between the power supply and the photoelectric conversion element 1 to switch the electrical connection. The resistance of the quenching element 204 may also be interconnection resistance, and it is also possible to omit a resistor from the equivalent circuit diagram.

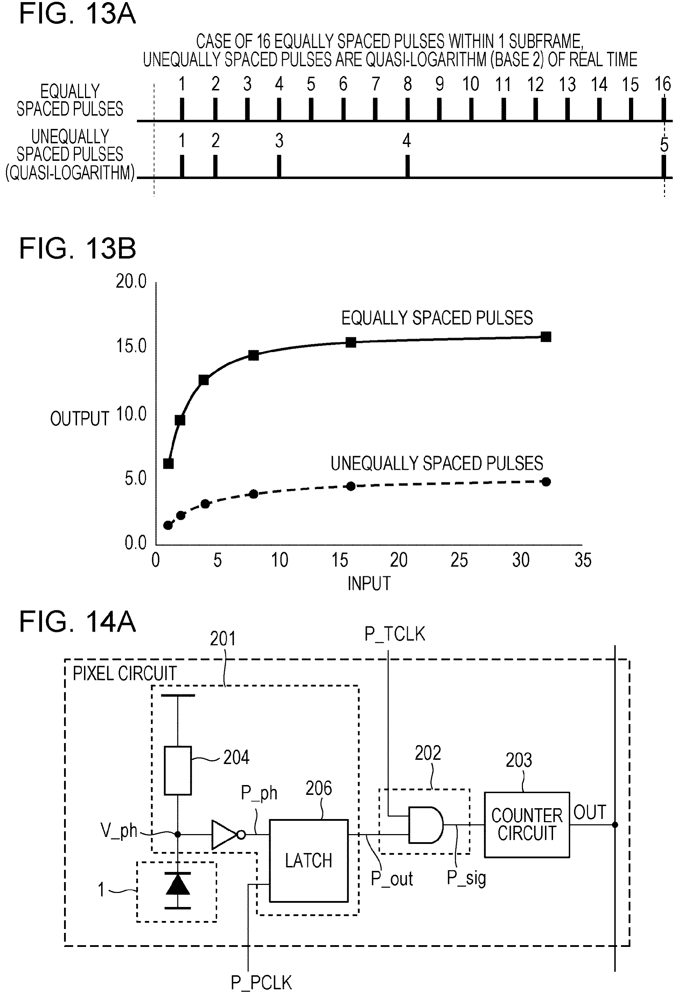

The waveform shaping circuit 205 shapes the potential change of the cathode of the photoelectric conversion element 1 obtained during photon detection, and outputs a pulse signal. For example, an inverter circuit is used as the waveform shaping circuit 205. Fig. 14A illustrates an example of using one inverter as the waveform shaping circuit 205, but a circuit in which multiple inverters are connected in series may also be used, or some other circuit with a waveform shaping effect may be used.

The timing determination circuit 202 is connected to the waveform shaping circuit 205 and the counter circuit 203. A signal outputted from the waveform shaping circuit 205 and P_TCLK supplied from outside the pixel are inputted, and a signal is outputted to the counter circuit 203 according to the combination of the inputted signals. Examples of this circuit include an AND circuit.

Fig. 10B illustrates the relationship of P_PCLK, V_ph (the cathode potential of the photoelectric conversion element 1), and P_ph (the output from the waveform shaping circuit 205) in clock recharge driving. At a time t1, P_PCLK transitions from an L level to an H level and the switch is turned on, which causes the cathode-side terminal of the photoelectric conversion element 1 to be electrically connected to the power supply voltage and a reverse bias to be applied to the photoelectric conversion element 1. In other words, charge mode is in effect when P_PCLK is at the H level and the switch is on. Charge mode is repeated multiple times, and thus is also referred to as recharge mode. If a reverse bias is applied, the cathode potential V_ph rises, and if a determination threshold is crossed, the output P_ph transitions from the H level to the L level. Thereafter, P_PCLK transitions from the H level to the L level, and the photoelectric conversion element 1 enters standby mode to wait for photon incidence. At a time t2, a photon is incident, whereupon the cathode potential V_ph falls, and at a time t3, the determination threshold is crossed, whereupon the output P_ph transitions from the L level to the H level. Thereafter, at a time t4, P_PCLK again transitions from the L level to the H level, the switch is turned on, which cases the operation described above to be repeated.

According to this clock recharge driving, an output signal can be counted at least one time even if many photons are incident during standby mode, and therefore this driving is effective as a pile-up countermeasure.

Fig. 10C is a truth table representing the output P_sig with respect to the inputs P_ph and P_TCLK into the timing determination circuit 202. In the truth table, 0 indicates the L level and 1 indicates the H level. Since the timing determination circuit 202 is configured as an AND circuit, the output P_sig goes to the H level only if the inputs P_ph and P_TCLK are both at the H level.

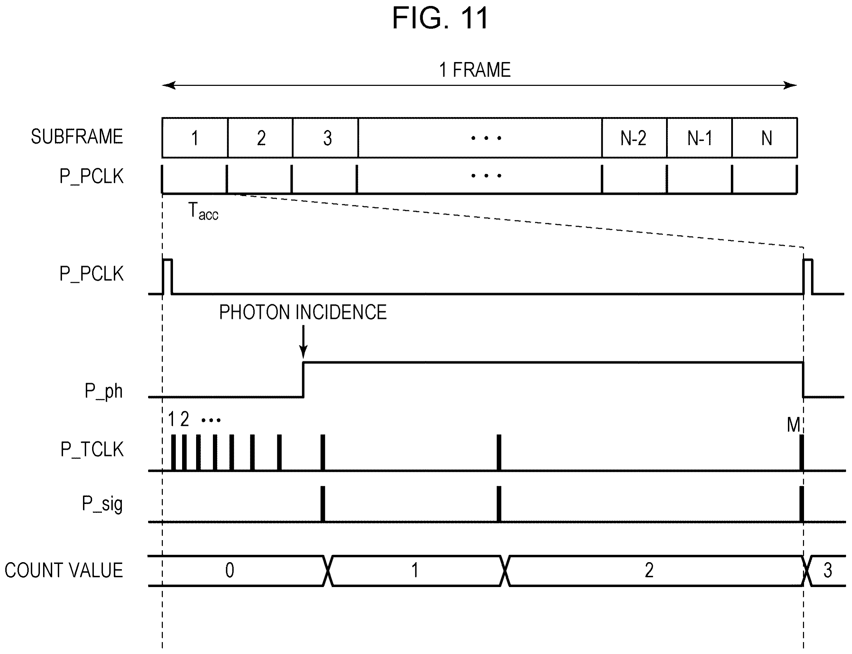

Fig. 11 is a drive timing diagram for explaining the exposure period and the pulse signal. The 1-frame period is made up of N subframes. The beginnings and the ends of the subframes are defined by P_PCLK. One subframe contains M pulses of P_TCLK, and P_TCLK is inputted into the timing determination circuit 202 such that pulses of the same periodicity are repeated for each subframe. In Fig. 11, P_TCLK is unequally spaced, and the spacing is proportional to a quasi-logarithm. As described later, P_TCLK may also be equally spaced. Unequally spaced pulses that are proportional to a quasi-reciprocal are also possible.

Fig. 11 embodies the concepts in Figs. 3A and 3B described above. The pulses of P_PCLK are the starting points of the subframes, and the spacing of the subframes is $T_{acc}$. P_ph transitions from the L level to the H level when a photon is incident, and transitions from the H level to the L level due to the recharge operation of the photoelectric conversion element 1 when a P_PCLK pulse is inputted. P_TCLK is a pulse signal for defining time information within a subframe.

In accordance with the configuration of the timing determination circuit 202 described in Fig. 10C, the number of P_TCLK from the timing when a photon is initially detected within a subframe is the value to be counted, and therefore the signal inputted into the counter is like P_sig, and 3 is counted in the counter. This count value is associated with the incidence of a photon in a time window from M-4 to M-3. In this way, if a photon is incident near the beginning of a subframe, the count value of the counter becomes a large value, whereas if a photon is incident near the end of the subframe, the count value of the counter becomes a small value. In other words, it is possible to measure, on the basis of P_TCLK, a numerical value that corresponds to the time from the beginning of a subframe until a photon is initially detected.

Such counting is repeated N times and the count values are summed to obtain a count value that corresponds to the expected value E' of the detection time. This makes it possible to estimate the number of incident photons from the expected value E', as described above.

According to this configuration, the number of incident photons during the exposure period can be estimated from the photon detection timings, making it possible to expand the dynamic range beyond the number of detected photons. Moreover, the length of the subframe period can be set by the photon exposure control unit, making it possible to adjust the exposure so that the counter does not saturate during the 1-frame period. For this reason, stopping of the counter during the 1-frame period can be avoided to prevent loss of signal information, while also ensuring dynamic range.

Incidentally, with conventional clock recharge driving in which the timing determination circuit 202 is not provided, the number of subframe periods is the maximum number that can be counted in the 1-frame period. For example, if the number of subframes is N, the maximum count value is N, and up to N photons can be detected. Also, the dynamic rage (defined as the maximum output value) is N. Specifically, since power consumption is proportional to the number of detections, if an attempt is made to reduce the number of detections in the aim of lowering power consumption, the dynamic range decreases, whereas if an attempt is made to increase the dynamic range, the power consumption rises. In other words, there is a trade-off between dynamic range and power consumption.

On the other hand, in a photoelectric conversion device according to the present embodiment in which the timing determination circuit 202 is provided, the estimated number of photons corresponds to the dynamic range. The power consumption is proportional to the number of detections as in the past, but since the estimated number of photons does not depend on the number of detections, the trade-off between dynamic range and power consumption can be resolved.

(Equally Spaced and Unequally Spaced P_TCLK)

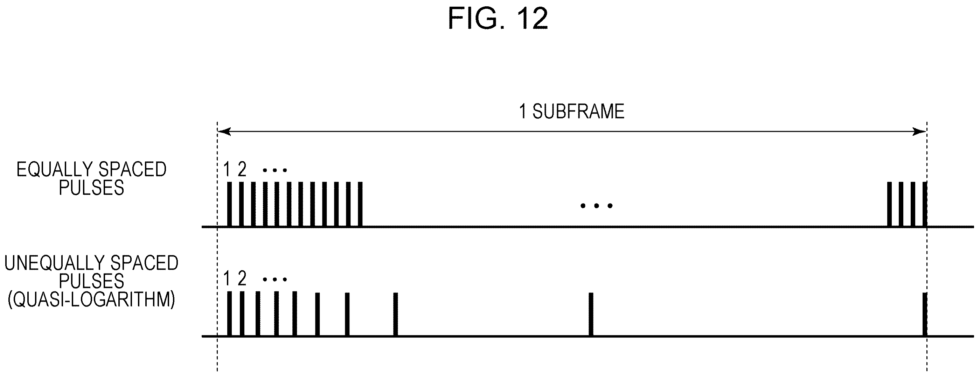

Fig. 12 is a conceptual diagram comparing cases where P_TCLK is equally spaced and unequally spaced. The upper part of Fig. 13A illustrates an example of generating 16 equally spaced pulses within one subframe. The equally spaced pulses can be said to correspond to real time. The lower part illustrates an example of generating unequally spaced pulses that occur at a quasi-logarithm (base 2) of real time. "Quasi" is used in this context because although the logarithm to the base 2 of 1 is 0 and the logarithm to the base 2 of 2 is 1, in Fig. 13A, 1 is added to allow for comparison with the equally spaced pulses, resulting in the values of 1 and 2, respectively. Such unequally spaced pulse spacing is expressed as setting the pulse space to be a logarithmic compression of real space.

Fig. 13B illustrates a graph plotting the relationship between the number of incident photons (input) and the count value (output), as compared to the same for equally spaced pulses. As illustrated in this diagram, when compared for the same number of incident photons (input), the output of the unequally spaced pulses is a smaller value than the output of the equally spaced pulses. That is, unequally spaced pulses allow for determinations using a smaller count value with respect to the same number of incident photons. This means that unequally spaced pulses make it possible to scale down the counter circuit and reduce the area of the pixel circuit. On the other hand, equally spaced pulses make it possible to reduce the average spacing between pulses, resulting in a relatively higher S/N compared to unequally spaced pulses.

(Second Embodiment)

The present embodiment describes an example of a configuration provided with a pixel circuit different from that of the first embodiment.

The difference between the pixel circuit of the present embodiment illustrated in Fig. 14A and the pixel circuit illustrated in Fig. 10A is that the switch that accepts input of P_PCLK provided between the power supply voltage and the photoelectric conversion element 1 is eliminated, and a latch circuit 206 is added to the signal processing circuit 201. P_PCLK is configured to be inputted into the latch circuit 206. Likewise in the case illustrated in Fig. 14A, any element that functions as a resistor may be provided as the quenching element 204, and therefore not only a metal resistor but also a transistor or the like may be used as the quenching element 204.

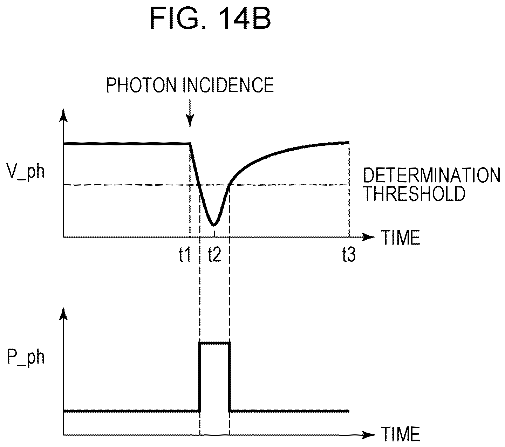

Fig. 14B illustrates change in the cathode potential V_ph of the photoelectric conversion element 1 illustrated in Fig. 14A. The difference with respect to Fig. 10B is that after a potential drop occurs in the cathode potential due to photon incidence, the voltage autonomously returns to the initial state. This pixel operation is referred to as passive operation.

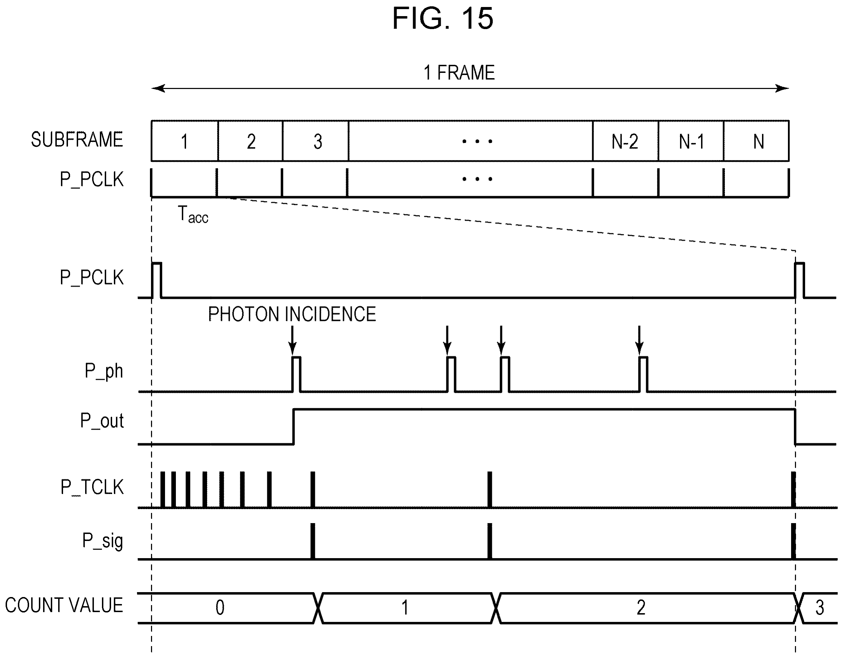

Fig. 15 is a drive timing diagram according to the present embodiment. The difference with respect to Fig. 11 is that P_ph goes high and low repeatedly in response to photon incidence within one subframe. However, P_out, which is outputted from the latch circuit 206 and inputted into the timing determination circuit, coincides with P_ph in Fig. 11, and thus P_sig outputted as a result is the same. In this way, effects similar to the first embodiment are obtained even with a passively driven ADP element.

In other words, according to this configuration, the number of incident photons during the exposure period can be estimated from the photon detection timings, making it possible to expand the dynamic range beyond the number of detected photons. Moreover, the length of the subframe period can be set by the photon exposure control unit, making it possible to adjust the exposure so that the counter does not saturate during the 1-frame period. For this reason, stopping of the counter during the 1-frame period can be avoided to prevent loss of signal information, while also ensuring dynamic range.

Moreover, according to the present configuration, since the estimated number of photons that corresponds to the dynamic range does not depend on the number of detections that corresponds to the power consumption, the trade-off between dynamic range and power consumption can be resolved.

(Third Embodiment)

The present embodiment describes an example of a configuration provided with a pixel circuit different from those of the embodiments above.

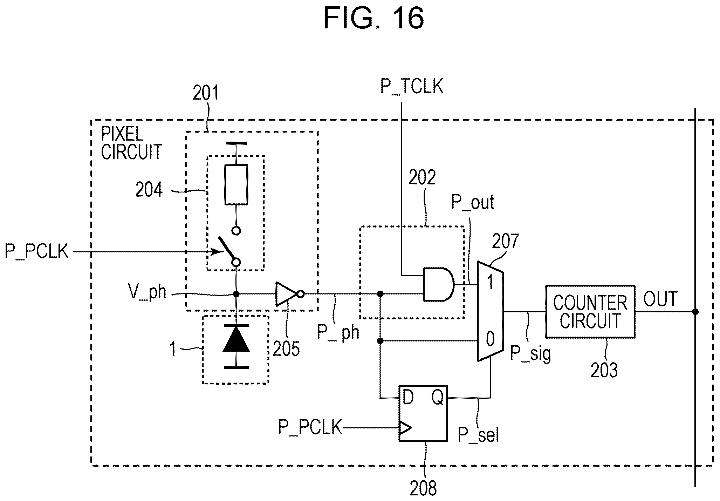

The difference between the pixel circuit of the present embodiment illustrated in Fig. 16 and the pixel circuit illustrated in Fig. 10A is that a signal select circuit 207 and a signal hold circuit 208 are added. The addition of these circuits makes it possible to switch between P_out and P_ph as the signal to be inputted into the counter circuit for the M-th subframe by referencing information pertaining to the presence or absence of photon incidence in the (M-1)-th subframe. Since the output of the subsequent subframe is changed according to the result of the previous subframe, this circuit is referred to herein as a time correlation filter.

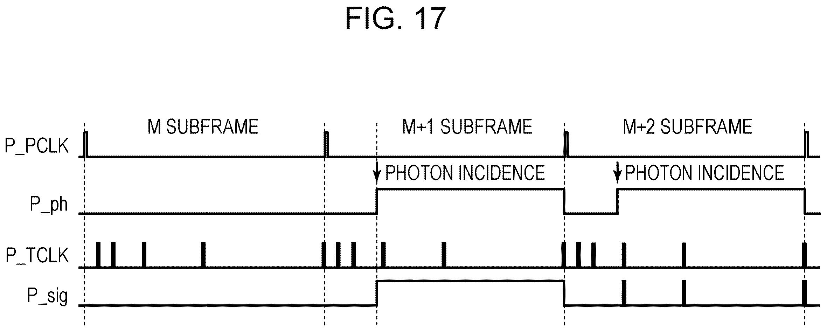

Fig. 17 illustrates an operating sequence of the present embodiment. In the M-th subframe, a photon is not incident, and therefore P_ph is at the L level. Information pertaining to the L level is held in the signal hold circuit 208.

Next, P_PCLK defining the beginning of the (M+1)-th subframe transitions from the L level to the H level, whereupon the L-level signal is outputted from the signal hold circuit 208, and the L-level signal is inputted into the signal select circuit 207. This configuration causes the signal select circuit 207 to output P_ph as P_sig instead of outputting P_out as P_sig. In the (M+1)-th subframe, a photon is incident, whereupon P_ph transitions from the L level to the H level, and thus P_sig also transitions from the L level to the H level. Also, since P_ph transitions from the L level to the H level, information pertaining to the H level is held in the signal hold circuit 208.

Next, P_PCLK defining the beginning of the (M+2)-th subframe transitions from the L level to the H level, whereupon P_ph transitions from the H level to the L level and P_sig also transitions from the H level to the L level. Also, the configuration is such that the level transition of P_PCLK causes the H-level signal to be outputted from the signal hold circuit 208, and the signal select circuit 207 outputs P_out as P_sig. In other words, this configuration allows the signal select circuit 207 to output a signal corresponding to the pulse signal defining time information within the (M+2)-th subframe period. In the (M+2)-th subframe, a photon is incident, whereupon P_ph transitions from the L level to the H level, and thus the signal of P_out is outputted as P_sig.

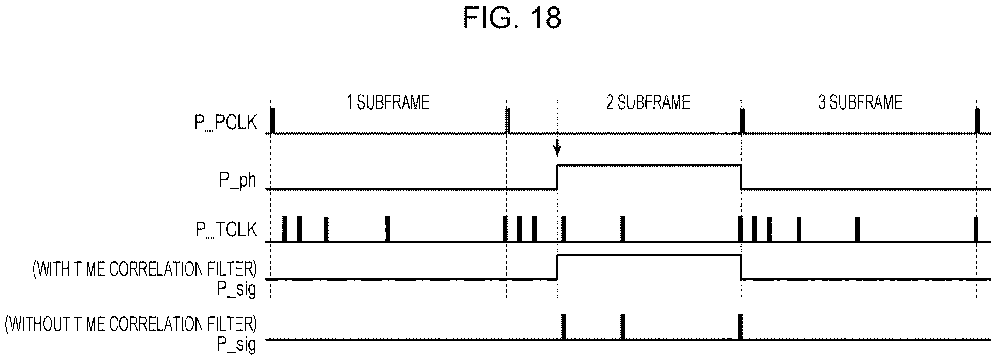

Fig. 18 illustrates an operating sequence for explaining the effect of the time correlation filter. The time correlation filter exhibits an effect in the case of handling a signal with about one count or fewer per subframe. This is because as the frequency of photon incidence decreases, the probability that a photon will be incident becomes constant irrespective of time, on the basis of the exponential distribution function. In other words, the probability of being in each time window is substantially the same probability.

In Fig. 18, one photon is incident in the 2nd subframe. In this way, when a photon is incident at the timing illustrated in Fig. 18, P_sig counts 1 in the case where the time correlation filter is present, and P_sig counts 3 in the case where the time correlation filter is absent.

If a configuration without the time correlation filter is adopted when handling a signal with about one count or fewer per subframe, the number of incident photons is counted as higher than the actual number of incident photons, and the error in the low illuminance region increases. In other words, this acts as a noise-increasing factor. In contrast, in the present embodiment, in the case of handling a signal with about one count or fewer per subframe, only one count is obtained as long as the signal is not detected continuously, and thus error can be suppressed and the noise-increasing factor can be reduced. For this reason, the SN ratio in the low output region can be improved. Furthermore, since the dark count rate (DCR) in dark conditions is also a signal with about one count or fewer per subframe, adopting the time correlation filter allows for a reduction in the DCR by the same principle.

Note that although the above describes an example of a circuit that outputs one count as long as the signal is not detected continuously, it is also possible to implement a circuit that outputs a prescribed value, the prescribed value being a value equal to or greater than one count.

(Fourth Embodiment)

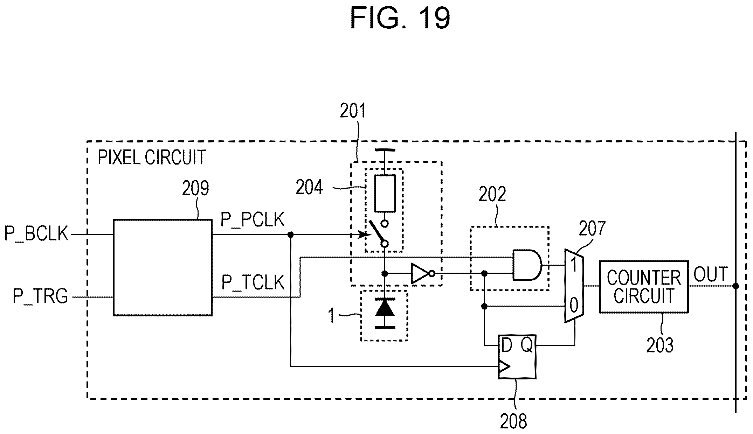

The difference between the pixel circuit of the present embodiment illustrated in Fig. 19 and the pixel circuit illustrated in Fig. 16 is that an in-pixel pulse generation circuit 209 is added. The in-pixel pulse generation circuit 209 is a circuit for generating P_PCLK and P_TCLK from a single base clock signal (herein, P_BCLK).

To measure the time from the beginning of a subframe until a photon arrives, P_PCLK that determines the beginning of the subframe and P_TCLK that measures a value corresponding to the elapsed time since the beginning of the subframe must not be at misaligned timings. This is because if the timings of these signals are misaligned, error in the measured values increases and the noise performance declines. The configuration according to the present embodiment eliminates the need to consider influences from outside the pixel circuit, making it possible to suppress misalignment of the timings.

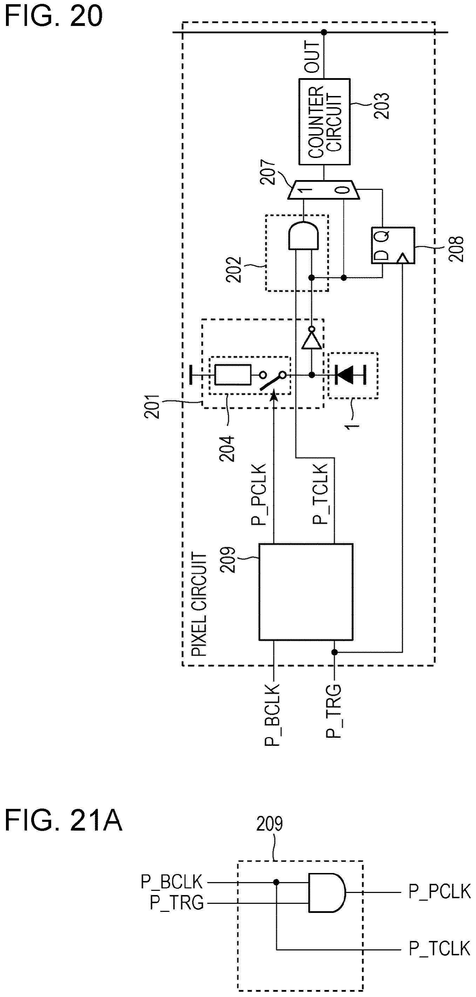

Fig. 20 is a modification of Fig. 19. P_TRG can be used as a trigger signal to be inputted into the signal hold circuit 208.

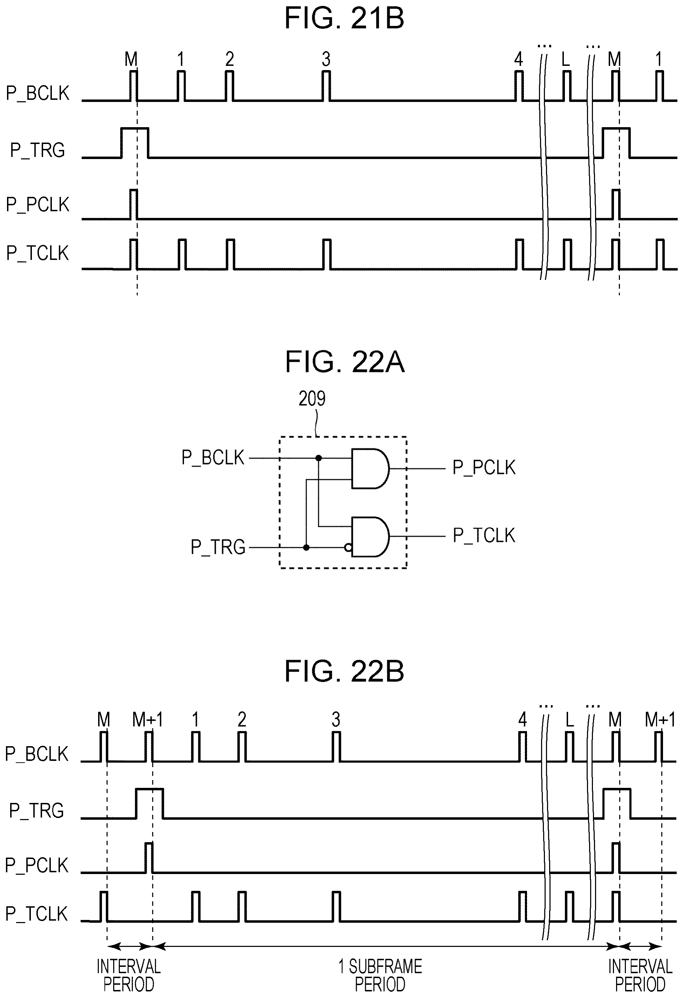

Fig. 21A illustrates a specific example of the in-pixel pulse generation circuit 209. Fig. 21B illustrates an operating sequence of the in-pixel pulse generation circuit 209. In Fig. 21A, P_BCLK is the base clock signal, and is inputted into an AND circuit. P_BCLK becomes P_TCLK, which measures a value corresponding to the elapsed time since the beginning of the subframe. The configuration is such that the trigger signal P_TRG is inputted into the AND circuit, and P_PCLK is outputted if P_TRG is at a high level. By adopting such a circuit configuration, P_PCLK and P_TCLK can be generated from a single base clock signal, thus suppressing misalignment of the timings.

Figs. 22A and 22B are modifications of Figs. 21A and 21B. As illustrated in Fig. 22A, the trigger signal P_TRG is inverted and inputted into an AND circuit. For this reason, the circuit is configured such that P_PCLK is outputted if P_TRG is at the H level, and P_TCLK is outputted if P_TRG is at the L level. As a result, the circuit is configured such that P_PCLK and P_TCLK do not overlap and an interval period is provided therebetween.

If P_PCLK and P_TCLK overlap, an anticipated problem is that the last P_TCLK may not be counted correctly, depending on the positional relationship of the two pulses. Accordingly, the problem can be resolved by defining the beginning of one subframe period by a P_PCLK pulse, namely the (M+1)-th pulse of P_BLK, and defining the end by the last P_TCLK, namely the M-th pulse of P_BLK.

(Fifth Embodiment)

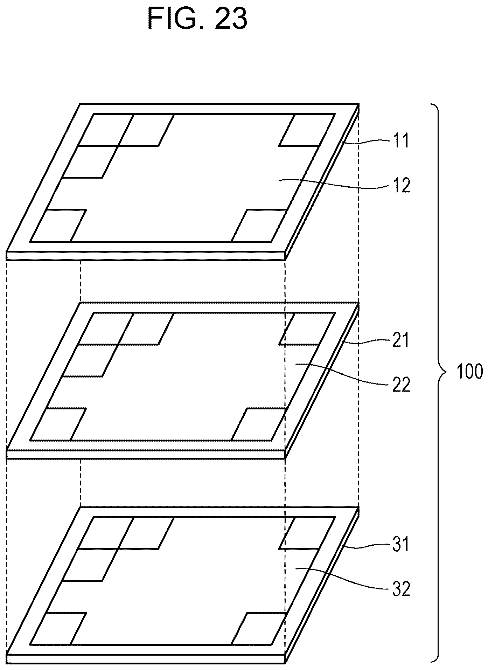

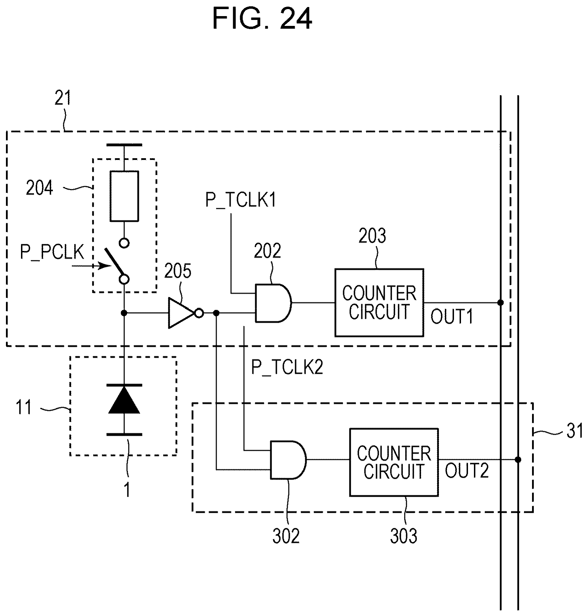

A fifth embodiment will be described using Figs. 23 and 24. The present embodiment differs by having a trilayer stack.

In Fig. 23, a third board 31 (third board) and a second circuit region 32 are added.

Fig. 24 illustrates a conceptual layout diagram of a pixel circuit in a trilayer stack. Compared to the pixel circuit in Fig. 10A, a second timing determination circuit 302 and a second counter circuit 303 are added, these circuits being disposed on the third board 31.

The circuit is configured such that the P_TCLK2 and the output from the waveform shaping circuit 205 are inputted into the second timing determination circuit 302. Fig. 24 illustrates a configuration in which P_TCLK2 is inputted into the third board 31 from a circuit provided on the circuit board 21, because it is assumed that the vertical scan circuit unit 110 and the control pulse generation unit 115 are provided on the circuit board 21. Since the third board 31 lacks the quenching element 204 and the waveform shaping circuit 205, more space is available compared to the circuit board 21. For this reason, it is also possible to provide the vertical scan circuit unit 110 and/or the control pulse generation unit 115 on the third board 31. In this case, a configuration may be adopted such that P_PCLK and P_TCLK1 are inputted into the circuit board 21 from the third board 31.

In the present embodiment, a trilayer stack is adopted, and therefore multiple circuits can be parallelized easily and more advanced functionality can be achieved. Specifically, since the timing determination circuits 202 and 302 are provided in parallel, P_TCLK1 and P_TCLK2 with different signal waveforms can be used to obtain two outputs with different count values from a single photon detection signal. The relative performance of various characteristics (such as dynamic range, SN ratio, correct exposure amount, and power consumption) changes depending on the number of pulses and the pulse spacing of P_TCLK. Accordingly, having two outputs with different characteristics also makes it possible to select the optimal output according to the imaging scene, or to combine the outputs to generate an image of higher quality.

For example, in the case of taking measurements using a single P_TCLK as in the first embodiment, an anticipated problem is that measurement error will increase when shooting a scene in which the light intensity changes suddenly within a single frame. This is because differences in the measured values of the photon detection timings in the subframes become larger compared to the case where average light is incident within a single frame.

One means for addressing this issue is to make a correction by acquiring signals in parallel so that light intensity changes within a single frame can be estimated. Specifically, this method can be achieved by adopting a configuration in which, for instance, only the initial pulse of P_TCLK2 is counted, so that only an incident photon with an early detection timing is counted.

(Sixth Embodiment)

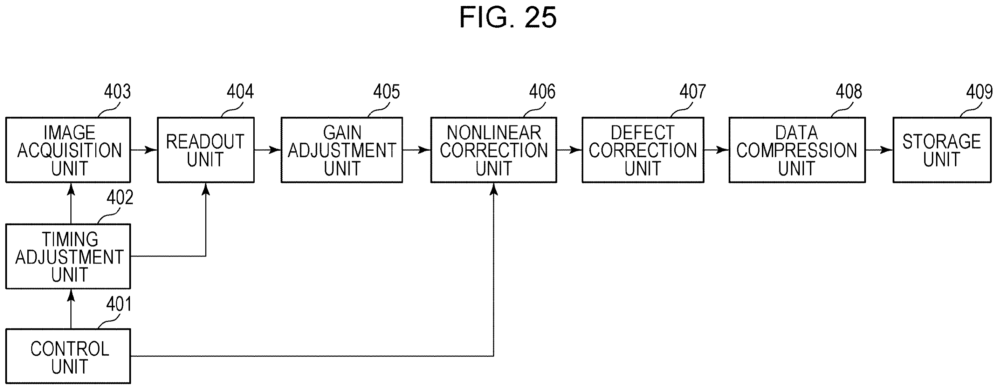

A photoelectric conversion system using the photoelectric conversion device according to any of the embodiments described above will be described using Fig. 25. Fig. 25 is a block diagram illustrating a schematic configuration of a photoelectric conversion system according to the present embodiment.

The processing device according to the present embodiment includes a control unit 401, a timing adjustment unit 402, an image acquisition unit 403, a readout unit 404, a gain adjustment unit 405, a nonlinear correction unit 406, a defect correction unit 407, a data compression unit 408, and a storage unit 409.

The image acquisition unit 403 is a pixel circuit, for example, and the readout unit 404 is provided downstream of the counter circuit 203, for example. The control unit 401 may also be a control unit internal to the photoelectric conversion device, or may be external to the photoelectric conversion device. The image acquisition unit 403 is controlled by the timing adjustment unit 402 that the control unit 401 controls. Image data generated by the image acquisition unit undergoes correction processes and is inputted into the storage unit 409. Note that the order of the correction processes is not limited to the order illustrated in Fig. 25.

The gain adjustment unit 405 is provided between the readout unit 404 and the nonlinear correction unit 406, and applies digital gain to the image data generated by the image acquisition unit 403. Data for image correction often contains fractional values, but in the case of integer-based image output, quantization error may result in lowered correction accuracy. By applying gain to the image data in advance, the influence of quantization error can be suppressed, and the correction accuracy can be raised. If the quantization error can be suppressed to no more than one-fourth of the single-photon signal level, the corrected image will appear visually natural. For this reason, it is desirable to apply a digital gain of 4x or more to the image data, for example.

The nonlinear correction unit 406 is disposed between the gain adjustment unit 405 and the defect correction unit 407, and corrects image data under control by the control unit 401. In a case where the image acquisition unit 403 is a photon-counting detector, the optical response often becomes nonlinear due to the influence of dead time. In a case of being under the influence of nonlinear optical response, making a correction predicated on linear response may result in overcorrection. For this reason, by making a nonlinear correction to the image data upstream of the computational processing in the defect correction unit 407, overcorrection can be prevented and appropriate nonlinear correction in accordance with the drive timings can be performed. This nonlinear correction is performed using a lookup table, for example.

The defect correction unit 407 corrects data from defective pixels included in the image data. As a specific example, an output value from a defective pixel is extracted, and information about the location of the defective pixel and the output value are identified. One method involves replacing the identified output value with the mean or the median value of the output from pixels surrounding the identified defective pixel. Another method involves division of estimated defective image data.

The data compression unit 408 compresses corrected image data. In the photoelectric conversion device according to the present invention, a massive amount of image data supporting high dynamic range is generated. By providing the data compression unit 408, the data can be compressed before being archived in the storage unit 409 downstream.

The storage unit 409 is a storage unit for retaining at least a portion of the image data generated upstream. Specifically, the image data is stored by using memory such as SRAM, DRAM, or non-volatile memory as the storage unit.

In this way, according to the present embodiment, a photoelectric conversion system to which is applied the photoelectric conversion device indicated in any of the embodiments described above can be achieved.

(Seventh Embodiment)

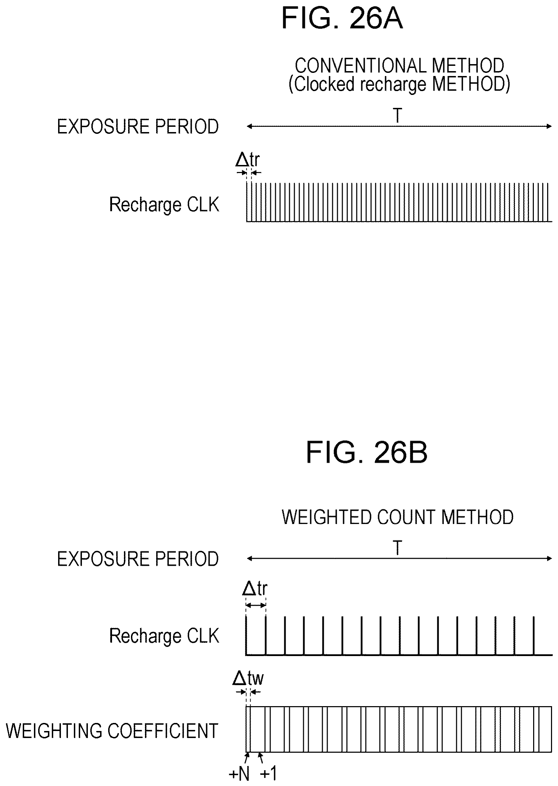

The effects of the present invention will be described further using Figs. 26A and 26B. In the following description, the case of performing addition according to the embodiments described above is referred to as the weighted count method.

In the conventional clocked recharge method illustrated in Fig. 26A, a maximum estimated number of incident photons is determined according to the number of Recharge CLK (P_PCLK). In other words, the higher the Recharge CLK number, the higher the dynamic range. On the other hand, since power consumption increases proportionally with the number of Recharge CLK, dynamic range and power consumption are in a trade-off.

Let T be the exposure period and let $\Delta tr$ be the pulse spacing of Recharge CLK, in which case the number of Recharge CLK is represented by $T / \Delta tr$, and therefore the dynamic range can also be thought of as being determined by $T / \Delta tr$.

In contrast, as illustrated in Fig. 26B, the weighted count method involves estimating the number of incident photons starting from the timing when a photon is incident. For this reason, the maximum estimated number of incident photons is determined by $T / \Delta tw$. In this context, $\Delta tw$ is the period from a pulse of Recharge CLK (in the embodiments, P_PCLK) until the initial P_TCLK pulse is inputted. In other words, the maximum estimated number of incident photons no longer depends on the Recharge CLK spacing $\Delta tr$, eliminating the trade-off between dynamic range and power consumption. Note that $\Delta tr / \Delta tw$ is preferable as the weighting coefficient (the amount by which to increase the count value corresponding to the incidence of one photon) in this situation.

The following indicates an example of specific numerical values. In the conventional method, when the exposure period T is set to 1024 and $\Delta tr$ is set to 1, the maximum number of avalanches is 1024, and the maximum number of detected incident photons at this time is 1024. On the other hand, in the weighted count method, when the exposure period T is set to 1024, $\Delta tr$ is set to 4, and $\Delta tw$ is set to 1, the maximum number of avalanches is 256. By adding to the counter circuit such that the count number corresponding to photons incident during $\Delta tw$ becomes 4, which is $\Delta tr / \Delta tw$, the maximum estimated number of incident photons at this time is 1024. In other words, the power consumption associated with recharge can be reduced to one-fourth of the conventional method while achieving a comparable dynamic range. In the embodiments described above, the adding of 4 at the timing of $\Delta tw$ is achievable by inputting four P_TCLK pulses within a time sufficiently shorter than $\Delta tw$, for example.

The reason why it is preferable to set the weighting coefficient to $\Delta tr / \Delta tw$ is that doing so makes the saturated count numbers equal under drive conditions in which both methods produce comparable dynamic ranges. Setting such conditions makes it possible to reduce aliasing or the like during nonlinear correction. However, since power consumption depends solely on $\Delta tr$ and not on the weighting coefficient, it is not strictly necessary to satisfy the above relational expression from the perspective of lowering power consumption.

(Eighth Embodiment)

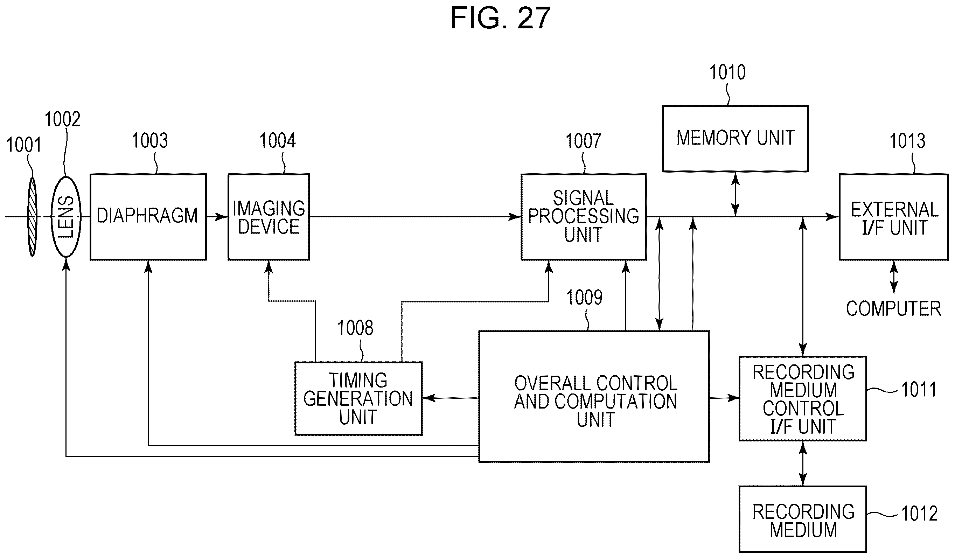

A photoelectric conversion system according to the present embodiment will be described using Fig. 27. Fig. 27 is a block diagram illustrating a schematic configuration of a photoelectric conversion system according to the present embodiment.

The photoelectric conversion device described in the embodiments above is applicable to a variety of photoelectric conversion systems. Examples of photoelectric conversion systems to which application is possible include digital still cameras, digital camcorders, surveillance cameras, photocopiers, fax machines, mobile phones, in-vehicle cameras, and observation satellites. Also, camera modules provided with an optical system, such as a lens, and an imaging device are also included among the above photoelectric conversion systems. As one such example, Fig. 27 illustrates an example of a block diagram of a digital still camera.

The photoelectric conversion system illustrated by way of example in Fig. 27 includes an imaging device 1004, which is an example of a photoelectric conversion device, and a lens 1002 that forms an optical image of a subject on the imaging device 1004. The photoelectric conversion system further includes a diaphragm 1003 for varying the amount of light that is to pass through the lens 1002, and a barrier 1001 for protecting the lens 1002. The lens 1002 and the diaphragm 1003 constitute an optical system that condenses light onto the imaging device 1004. The imaging device 1004 is the photoelectric conversion device according to any of the embodiments above, and converts an optical image formed by the lens 1002 into an electrical signal.

The photoelectric conversion system includes a signal processing unit 1007, which is an image generation unit that generates an image by processing an output signal outputted by the imaging device 1004. The signal processing unit 1007 performs operations for applying types of various of correction and compression, as needed, and outputting image data. The signal processing unit 1007 may be formed in a semiconductor layer where the imaging device 1004 is provided, and may also be formed in a semiconductor layer separate from the imaging device 1004. The imaging device 1004 and the signal processing unit 1007 may also be formed in the same semiconductor layer.

The photoelectric conversion system further includes a memory unit 1010 for temporarily storing image data and an external interface unit (external I/F unit) 1013 for communicating with an external computer or the like. Furthermore, the photoelectric conversion system includes a recording medium 1012 such as semiconductor memory for recording or reading out imaging data and a recording medium control interface unit (recording medium control I/F unit) 1011 for recording or reading out with respect to a recording medium 1012. Note that the recording medium 1012 may also be built into, or removably attachable to, the photoelectric conversion system.

Furthermore, the photoelectric conversion system includes an overall control and computation unit 1009 that controls various computations and the digital still camera as a whole, and a timing generation unit 1008 that outputs various timing signals to the imaging device 1004 and the signal processing unit 1007. Timing signals or the like may also be inputted from an external source, and the photoelectric conversion system may at least include the imaging device 1004 and the signal processing unit 1007 that processes an output signal outputted from the imaging device 1004.

The imaging device 1004 outputs an imaging signal to the signal processing unit 1007. The signal processing unit 1007 performs prescribed signal processing on the imaging signal outputted from the imaging device 1004, and outputs image data. The signal processing unit 1007 uses the imaging signal to generate an image.

In this way, according to the present embodiment, a photoelectric conversion system to which is applied the photoelectric conversion device (imaging device) according to any of the embodiments above can be achieved.

(Ninth Embodiment)

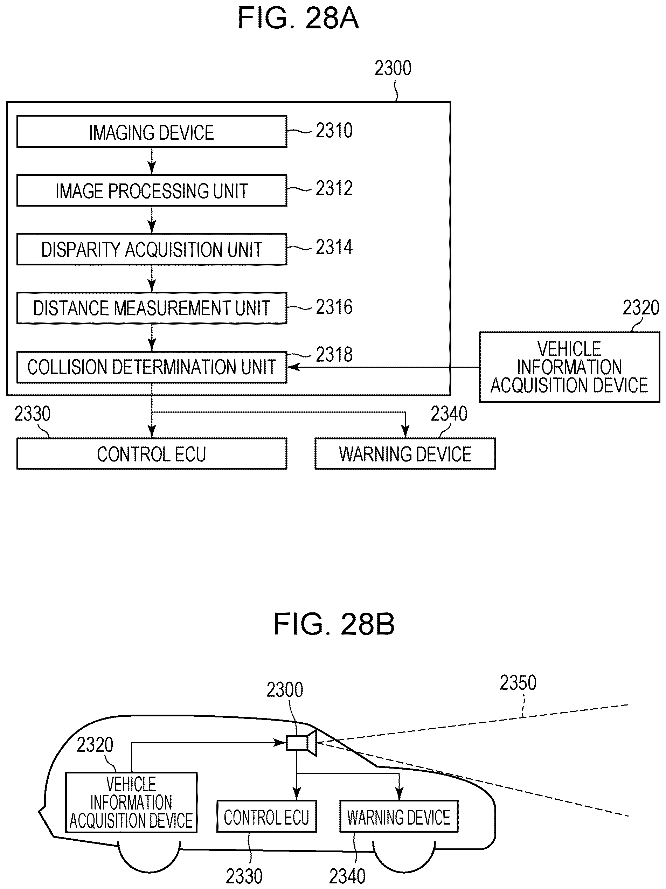

A photoelectric conversion system and a moving body according to the present embodiment will be described using Figs. 28A and 28B. Figs. 28A and 28B are diagrams illustrating a configuration of a photoelectric conversion system and a configuration of a moving body according to the present embodiment.

Fig. 28A illustrates an example of a photoelectric conversion system pertaining to an in-vehicle camera. The photoelectric conversion system 2300 includes an imaging device 2310. The imaging device 2310 is the photoelectric conversion device according to any of the embodiments above. The photoelectric conversion system 2300 includes an image processing unit 2312 that performs image processing on a plurality of image data acquired by the imaging device 2310. The photoelectric conversion system 2300 also includes a disparity acquisition unit 2314 that calculates the disparity (phase difference between disparity images) from the plurality of image data acquired by the photoelectric conversion system 2300. Furthermore, the photoelectric conversion system 2300 includes a distance measurement unit 2316 that calculates the distance to an object on the basis of the calculated disparity and a collision determination unit 2318 that determines whether or not collision is likely on the basis of the calculated distance. In this context, the disparity acquisition unit 2314 and the distance measurement unit 2316 are an example of a distance information acquisition means that acquires information about the distance to an object. In other words, distance information may also be acquired by using not only phase difference but also the time of flight (ToF) technique. The collision determination unit 2318 may use any of these types of distance information to determine whether collision is likely. The distance information acquisition means may be achieved by specially designed hardware, and may also be achieved by a software module. The distance information acquisition unit may also be achieved by a field-programmable gate array (FPGA), an application-specific integrated circuit (ASIC), or the like, and may also be achieved by a combination of the above.

The photoelectric conversion system 2300 is connected to a vehicle information acquisition device 2320 and can acquire vehicle information such as the vehicle speed, the yaw rate, and the steering angle. The photoelectric conversion system 2300 is also connected to a control ECU 2330, which is a control device (control unit) that outputs a control signal for generating braking force in the vehicle on the basis of a determination result in a collision determination unit 2318. The photoelectric conversion system 2300 is also connected to a warning device 2340 that issues a warning to a driver on the basis of the determination result in the collision determination unit 2318. For example, if collision is likely according to the determination result from the collision determination unit 2318, the control ECU 2330 carries out vehicle control to apply brakes, return an accelerator, limit engine output, and/or the like to avoid collision or mitigate damage. The warning device 2340 warns a user by, for instance, emitting a sound or other alarm, displaying warning information on a screen of a car navigation system or the like, and applying vibration to a seatbelt and/or a steering wheel.

In the present embodiment, the vehicle surroundings, such as ahead and behind, are imaged by the photoelectric conversion system 2300. Fig. 28B illustrates a photoelectric conversion system for the case of imaging a range (imaging range 2350) ahead of the vehicle. The vehicle information acquisition device 2320 sends instructions to the photoelectric conversion system 2300 and the imaging device 2310. According to such a configuration, the accuracy of distance measurement can be improved.

The above describes an example of carrying out control to avoid collision with another vehicle, but the above is also applicable to, for instance, control for self-driving by following another vehicle and control for self-driving so as not to depart from a lane. Furthermore, the photoelectric conversion system is not limited to vehicles such as automobiles, and can be applied to moving bodies (moving devices) such as marine vessels, aircraft, and industrial robots, for example. In addition, the photoelectric conversion system is not limited to moving bodies and can be applied to equipment such as intelligent transport systems (ITS) that extensively utilize object recognition.

(10th Embodiment)

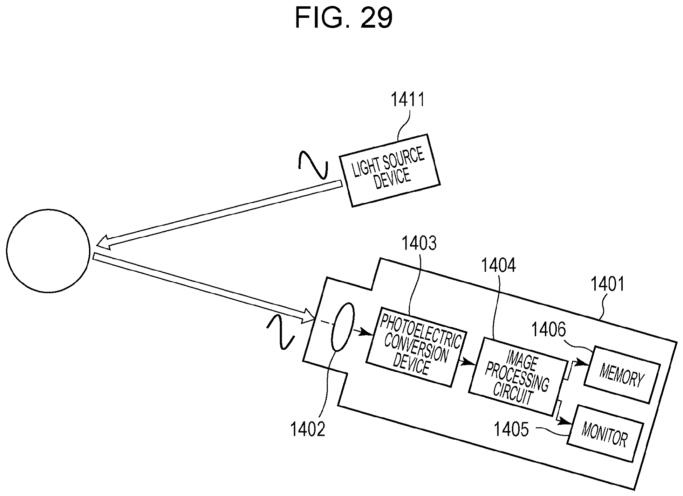

A photoelectric conversion system according to the present embodiment will be described using Fig. 29. Fig. 29 is a block diagram illustrating an example of the configuration of a distance image sensor, which is a photoelectric conversion system.

As illustrated in Fig. 29, the distance image sensor 1401 is configured to include an optical system 1402, a photoelectric conversion device 1403, an image processing circuit 1404, a monitor 1405, and memory 1406. The distance image sensor 1401 can receive light (modulated light or pulsed light) that is projected from a light source device 1411 toward a subject and then reflected off the surface of the subject, and thereby acquire a distance image in accordance with the distance to the subject.

The optical system 1402 is configured to include one or more lenses, guides image light (incident light) from a subject to the photoelectric conversion device 1403, and forms an image on a light-receiving surface (sensor unit) of the photoelectric conversion device 1403.

The photoelectric conversion device according to any of the embodiments described above is applied as the photoelectric conversion device 1403, and a distance signal indicating a distance obtained from a light reception signal outputted from the photoelectric conversion device 1403 is supplied to the image processing circuit 1404.

The image processing circuit 1404 performs image processing for constructing a distance image on the basis of the distance signal supplied by the photoelectric conversion device 1403. The distance image (image data) obtained by the image processing is then supplied to the monitor 1405 and displayed, and/or supplied to the memory 1406 and stored (recorded).

By applying the photoelectric conversion device described above to the distance image sensor 1401 configured in this way, the improvements in the pixel characteristics allow for the acquisition of a more accurate distance image, for example.

(11th Embodiment)

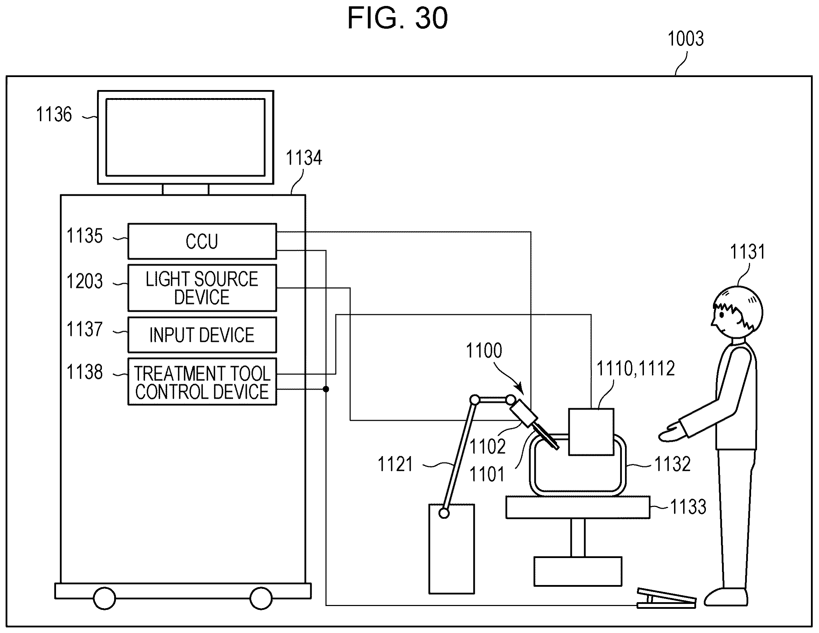

A photoelectric conversion system according to the present embodiment will be described using Fig. 30. Fig. 30 is a diagram illustrating an example of a schematic configuration of an endoscopic surgical system, which is a photoelectric conversion system according to the present embodiment.

Fig. 30 illustrates a situation in which a surgeon (physician) 1131 uses the endoscopic surgical system 1103 to perform surgery on a patient 1132 lying on a patient bed 1133. As illustrated in the diagram, the endoscopic surgical system 1103 is formed from an endoscope 1100, a surgical instrument 1110, and a cart 1134 carrying various devices for endoscopic surgery.

The endoscope 1100 is formed from a lens tube 1101 having a region of prescribed length from the leading end thereof that is to be inserted into a body cavity of the patient 1132, and a camera head 1102 connected to the base end of the lens tube 1101. The example in the diagram illustrates an endoscope 1100 configured as a so-called rigid scope having a rigid lens tube 1101, but the endoscope 1100 may also be configured as a so-called flexible scope having a flexible lens tube.

An opening fitted with an objective lens is provided at the leading end of the lens tube 1101. A light source device 1203 is connected to the endoscope 1100, and light generated by the light source device 1203 is guided to the leading end of the lens tube by a light guide laid out inside the lens tube 1101 and radiated via the objective lens toward an observation target in the body cavity of the patient 1132. Note that the endoscope 1100 may be a forward-viewing scope, and may also be an oblique-viewing scope or a side-viewing scope.

An optical system and a photoelectric conversion device are provided inside the camera head 1102, and reflected light (observation light) from the observation target is condensed onto the photoelectric conversion device by the optical system. The observation light is photoelectrically converted by the photoelectric conversion device, and an electrical signal corresponding to the observation light, or in other words an image signal corresponding to an observation image, is generated. The photoelectric conversion device according to any of the embodiments described above can be used as the photoelectric conversion device. The image signal is transmitted as RAW data to a camera control unit (CCU) 1135.

The CCU 1135 is configured using a central processing unit (CPU), a graphics processing unit (GPU), and/or the like, and centrally controls operations by the endoscope 1100 and a display device 1136. Furthermore, the CCU 1135 receives an image signal from the camera head 1102 and subjects the image signal to various image processing, such as development processing (demosaicing processing) for example, for displaying an image based on the image signal.

The display device 1136, under control by the CCU 1135, displays an image based on the image signal subjected to image processing by the CCU 1135.

The light source device 1203 is formed from a light source such as a light-emitting diode (LED) for example, and supplies the endoscope 1100 with irradiating light when taking an image of a surgical site or the like.

The input device 1137 is an input interface for the endoscopic surgical system 1103. A user can, via the input device 1137, input various information and/or instructions into the endoscopic surgical system 1103.

The treatment tool control device 1138 controls the driving of an energy treatment tool 1112 for tissue cauterization and incision, blood vessel sealing, and/or the like.

The light source device 1203 that supplies the endoscope 1100 with irradiating light when taking an image of a surgical site can be formed from a white light source configured using an LED, a laser light source, or a combination thereof, for example. In a case where the white light source is configured using a combination of RGB laser light sources, the output intensity and the output timing of individual colors (individual wavelengths) can be controlled precisely, thus allowing for adjustment of the white balance of a captured image in the light source device 1203. Moreover, in this case, by performing time-division irradiation of the observation target with laser light from each of the RGB laser light sources and controlling the driving of an imaging element of the camera head 1102 in synchronization with the irradiation timings, it is also possible to perform time-division capture of images corresponding to R, G, and B, respectively. According to this method, a color image can be obtained even if the imaging element is not provided with a color filter.

The driving of the light source device 1203 may also be controlled such that the intensity of the outputted light changes at intervals of a prescribed time. By controlling the driving of the imaging element of the camera head 1102 in synchronization with the timings of the changes in the intensity of the light to acquire images by time division and then combining the images, a high dynamic range image without so-called crushed blacks or blown highlights can be generated.

The light source device 1203 may also be configured to be capable of supplying light in a prescribed wavelength band corresponding to special light observation. Special light observation utilizes the wavelength dependence of light absorption in body tissues, for example. Specifically, high-contrast images of prescribed tissues such as blood vessels in a mucosal surface layer are taken by radiating light in a narrower band compared to the light (in other words, white light) radiated during normal observation. Alternatively, in special light observation, fluorescence observation may be performed to obtain an image through fluorescence generated by radiating excitation light. In fluorescence observation, a body tissue is irradiated with excitation light and the fluorescence from the body tissue is observed, or a reagent such as indocyanine green (ICG) is locally injected into a body tissue and the body tissue is irradiated with excitation light corresponding to the fluorescence wavelength of the reagent to obtain a fluorescence image. The light source device 1203 may be configured to be capable of supplying narrow-band light and/or excitation light corresponding to such special light observation.

(12th Embodiment)

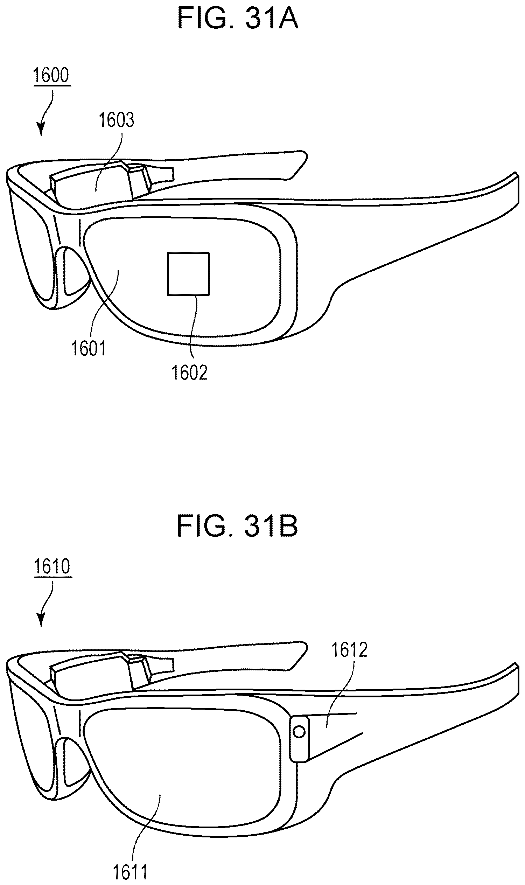

A photoelectric conversion system and a moving body according to the present embodiment will be described using Figs. 31A and 31B. Fig. 31A is a diagram illustrating an example of the configuration of eyeglasses 1600 (smart glasses), which are a photoelectric conversion system.

The eyeglasses 1600 have a photoelectric conversion device 1602. The photoelectric conversion device 1602 is the photoelectric conversion device according to the 12th embodiment above. Also, a display device including a light-emitting device such as an OLED or an LED may be provided on the back side of a lens 1601. There may be one or multiple photoelectric conversion devices 1602. Multiple types of photoelectric conversion devices may also be combined and used. The placement position of the photoelectric conversion device 1602 is not limited to Fig. 31A.

The eyeglasses 1600 is further provided with a control device 1603. The control device 1603 functions as a power supply that supplies electric power to the photoelectric conversion device 1602 and the above display device. Also, the control device 1603 controls operations by the photoelectric conversion device 1602 and the display device. In the lens 1601, an optical system for condensing light onto the photoelectric conversion device 1602 is formed.

Fig. 31B is for explaining eyeglasses 1610 (smart glasses) according to one example of application. The eyeglasses 1610 have a control device 1612, and a photoelectric conversion device corresponding to the photoelectric conversion device 1602 and a display device are installed in the control device 1612. In a lens 1611, an optical system for projecting light emitted from the photoelectric conversion device and the display device inside the control device 1612 is formed, and an image is projected onto the lens 1611. The control device 1612 functions as a power supply that supplies electric power to the photoelectric conversion device and the display device, and also controls operations by the photoelectric conversion device and the display device. The control device may also have a gaze detection unit that detects the gaze of a wearer. The detection of gaze may involve the use of infrared rays. An infrared light-emitting unit emits infrared light toward the eyeball of a user who is gazing at a display image. An imaging unit having a photoelectric conversion element detects light resulting from the emitted infrared light being reflected off the eyeball, thereby obtaining a captured image of the eyeball. Degradation of image quality is reduced by the inclusion of a reduction means that reduces light from the infrared light-emitting unit to a display unit in plan view.

The gaze of the user with respect to the display image is detected from the captured image of the eyeball obtained by the imaging of infrared light. Any well-known technique can be applied to the gaze detection using a captured image of the eyeball. As an example, a gaze detection method based on a Purkinje image obtained by the reflection of irradiating light off the cornea can be used.

More specifically, gaze detection processing based on the pupil center corneal reflection method is performed. In the pupil center corneal reflection method, the gaze of the user is detected by calculating a gaze vector representing the orientation (rotational angle) of the eyeball on the basis of an image of the pupil center and a Purkinje image included in a captured image of the eyeball.

The display device according to the present embodiment may have a photoelectric conversion device having a photoelectric conversion element, and may control a display image on the display device on the basis of user gaze information from the photoelectric conversion device.

Specifically, in the display device, a first visual field area that the user is gazing at and a second visual field area other than the first visual field area are determined on the basis of the gaze information. The first visual field area and the second visual field area may be determined by a control device of the display device, or a determination made by an external control device may be received. A display area of the display device may be controlled such that the display resolution of the first visual field area is higher than the display resolution of the second visual field area. In other words, the resolution of the second visual field area may be lowered compared to the first visual field area.

Also, the display area may be a first display area and a second display area different from the first display area, and an area of high priority may be determined from out of the first display area and the second display area on the basis of the gaze information. The first visual field area and the second visual field area may be determined by a control device of the display device, or a determination made by an external control device may be received. Control may be applied such that the resolution of the area of high priority is higher than the resolution of an area other than the area of high priority. In other words, the resolution of the area of relatively lower priority may be lowered.

Note that AI may also be used in the determination of the first visual field area and/or the area of high priority. The AI may be a model configured to estimate the angle of a gaze and the distance to an object of interest at the end of the gaze from an image of an eyeball, using images of eyeballs and the direction in which the eyeball in each of the images was actually looking as labeled training data. An AI program may be included in the display device, may be included in the photoelectric conversion device, or may be included in an external device. In the case of being included in an external device, the AI program is conveyed to the display device via communication.

In the case of carrying out display control on the basis of visual detection, the present invention can be favorably applied to smart glasses further having a photoelectric conversion device that captures images of the external world. Smart glasses can display captured external information in real time.

The embodiments described above can be modified, as appropriate, within a scope that does not depart from the technical concepts. Also, examples in which a portion of the configuration of any of the embodiments is added to another embodiment or used as a replacement for a portion of the configuration of another embodiment are also included among embodiments of the present invention.

Also, the disclosure of the embodiments includes the following configurations and methods.

(Configuration 1)

A photoelectric conversion device comprising:

a photoelectric conversion element that receives photons;

an exposure control unit that generates a signal defining a plurality of second exposure periods which are included in a first exposure period corresponding to one frame and which are each shorter than the first exposure period;

a timing generation unit that generates a pulse signal defining time information within each of the second exposure periods; and

a measurement unit that measures a number of the pulse signal from an initial detection of a photon in each of the second exposure periods, based on the pulse signal generated by the timing generation unit.

(Configuration 2)

The photoelectric conversion device according to configuration 1, wherein

the timing generation unit generates an equally spaced pulse signal, and
the pulse signal is configured to be inputted into the measurement unit in at least each of the second exposure periods.

(Configuration 3)

The photoelectric conversion device according to configuration 1, wherein

the timing generation unit generates an unequally spaced pulse signal, and
the pulse signal is configured to be inputted into the measurement unit in at least each of the second exposure periods.

(Configuration 4)

The photoelectric conversion device according to configuration 3, wherein
the unequally spaced pulse signal is configured such that a period thereof increases according to elapsed time in each of the second exposure periods.

(Configuration 5)

The photoelectric conversion device according to configuration 3 or 4, characterized in that
a spacing of the unequally spaced pulse signal is set to be a logarithmic compression of real space.

(Configuration 6)

The photoelectric conversion device according to any of configurations 1 to 5, characterized in that
the measurement unit includes a waveform shaping circuit that converts a signal from the photoelectric conversion element into a pulse signal.

(Configuration 7)

The photoelectric conversion device according to any of configurations 1 to 6, characterized in that

the measurement unit includes a timing determination circuit, and
the timing determination circuit outputs a pulse signal generated by the timing generation unit from a timing at which a photon is initially detected within each of the second exposure periods.

(Configuration 8)

The photoelectric conversion device according to configuration 7, wherein

the measurement unit includes a counter circuit, and the counter circuit obtains a count value by counting each input of a pulse signal outputted from the timing determination circuit within each of the second exposure periods.

(Configuration 9)

The photoelectric conversion device according to configuration 8, characterized in that
the counter circuit outputs the sum of the count values for the plurality of second exposure periods.

(Configuration 10)

The photoelectric conversion device according to any one of configurations 1 to 9, characterized in that the photoelectric conversion element is an avalanche photodiode.

(Configuration 11)

The photoelectric conversion device according to configuration 10, wherein
a switch for performing a charge operation is disposed between the avalanche photodiode and a power supply that applies a reverse bias to the avalanche photodiode.

(Configuration 12)

The photoelectric conversion device according to configuration 11, wherein
each of the second exposure periods is a period from a timing at which the charge operation is performed to a timing at which the next charge operation is performed.

(Configuration 13)

The photoelectric conversion device according to configuration 11, wherein
a pulse signal inputted into the switch for performing the charge operation and the pulse signal generated by the timing generation unit are generated from a base clock signal.

(Configuration 14)

The photoelectric conversion device according to any of configurations 1 to 13, wherein

the measurement unit has a select circuit,
the plurality of second exposure periods include one second exposure period and another second exposure period, and

the select circuit selects whether or not to output a signal corresponding to the pulse signal defining time information within the other second exposure period depending on whether a photon is not detected or is detected in the one second exposure period.

(Configuration 15)

The photoelectric conversion device according to configuration 14, characterized in that

if a photon is not detected in the one second exposure period, the select circuit outputs a prescribed value, irrespectively of the time from the beginning of the other second exposure period until a photon is initially detected.

(Configuration 16)

The photoelectric conversion device according to any of configurations 1 to 15, wherein

a first board and a second board are stacked,
the first board has the photoelectric conversion element, and
the second board has the exposure control unit, the timing generation unit, and the measurement unit.

(Configuration 17)

The photoelectric conversion device according to configuration 8, wherein

a first board, a second board, and a third board are stacked,
the first board has the photoelectric conversion element, and
the second board has the waveform shaping circuit, the timing determination circuit, and the counter circuit, and
the third board has the timing determination circuit and the counter circuit.

(Configuration 18)

The photoelectric conversion device according to configuration 17, wherein

a pulse signal generated by the timing generation unit to be inputted into the timing determination circuit provided on the second board and
a pulse signal generated by the timing generation unit to be inputted into the timing determination circuit provided on the third board are different.

(Configuration 19)

A photoelectric conversion system comprising:

the photoelectric conversion device according to any of configurations 1 to 18; and
a signal processing unit that generates an image using a signal outputted by the photoelectric conversion device.

(Configuration 20)

A moving body including the photoelectric conversion device according to any of configurations 1 to 18, wherein

the moving body has a control unit that controls movement of the moving body using a signal outputted by the photoelectric conversion device.

The present invention is not limited to the embodiments above, and various changes and modifications are possible without departing from the spirit and scope of the present invention. Accordingly, the following claims are attached to make public the scope of the invention.

This application claims the benefit of Japanese Patent Application No. 2023-108681 filed June 30, 2023 and No. 2024-102830 filed June 26, 2024, which are hereby incorporated by reference herein in their entirety.

Industrial Applicability

Reference Signs List

| | |
|---|---|
| 1 | photoelectric conversion device |
| 2 | exposure control unit |
| 3 | timing generation unit |
| 4 | measurement unit |
| 201 | signal processing circuit |
| 202 | timing determination circuit |
| 203 | counter circuit |
| 204 | quenching element |
| 205 | waveform shaping circuit |
| 206 | latch circuit |
| 207 | signal select circuit |
| 208 | signal hold circuit |
| 209 | in-pixel pulse generation circuit |

**Claims**

1. A photoelectric conversion device comprising:

a photoelectric conversion element that receives photons;
an exposure control unit that generates a signal defining a plurality of second exposure periods which are included in a first exposure period corresponding to one frame and which are each shorter than the first exposure period;
a timing generation unit that generates a pulse signal defining time information within each of the second exposure periods; and
a measurement unit that measures a number of the pulse signal from an initial detection of a photon in each of the second exposure periods, based on the pulse signal generated by the timing generation unit.

2. The photoelectric conversion device according to claim 1, wherein

   the timing generation unit generates an equally spaced pulse signal, and
   the pulse signal is configured to be inputted into the measurement unit in at least each of the second exposure periods.

3. The photoelectric conversion device according to claim 1, wherein

   the timing generation unit generates an unequally spaced pulse signal, and
   the pulse signal is configured to be inputted into the measurement unit in at least each of the second exposure periods.

4. The photoelectric conversion device according to claim 3, wherein
   the unequally spaced pulse signal is configured such that a period thereof increases according to elapsed time in each of the second exposure periods.

5. The photoelectric conversion device according to claim 4, **characterized in that**
   a spacing of the unequally spaced pulse signal is set to be a logarithmic compression of real space.

6. The photoelectric conversion device according to claim 1, **characterized in that**
   the measurement unit includes a waveform shaping circuit that converts a signal from the photoelectric conversion element into a pulse signal.

7. The photoelectric conversion device according to claim 6, **characterized in that**

   the measurement unit includes a timing determination circuit, and
   the timing determination circuit outputs a pulse signal generated by the timing generation unit from a timing at which a photon is initially detected within each of the second exposure periods.

8. The photoelectric conversion device according to claim 7, wherein

   the measurement unit includes a counter circuit, and
   the counter circuit obtains a count value by counting each input of a pulse signal outputted from the timing determination circuit within each of the second exposure periods.

9. The photoelectric conversion device according to claim 8, **characterized in that**
   the counter circuit outputs the sum of the count values for the plurality of second exposure periods.

10. The photoelectric conversion device according to claim 1, **characterized in that**
    the photoelectric conversion element is an avalanche photodiode.

11. The photoelectric conversion device according to claim 10, wherein
    a switch for performing a charge operation is disposed between the avalanche photodiode and a power supply that applies a reverse bias to the avalanche photodiode.

12. The photoelectric conversion device according to claim 11, wherein
    each of the second exposure periods is a period from a timing at which the charge operation is performed to a timing at which the next charge operation is performed.

13. The photoelectric conversion device according to claim 11, wherein
    a pulse signal inputted into the switch for performing the charge operation and the pulse signal generated by the timing generation unit are generated from a base clock signal.

14. The photoelectric conversion device according to claim 1, wherein

    the measurement unit has a select circuit,
    the plurality of second exposure periods include one second exposure period and another second exposure period, and
    the select circuit selects whether or not to output a signal corresponding to the pulse signal defining time information within the other second exposure period depending on whether a photon is not detected or is detected in the one second exposure period.

15. The photoelectric conversion device according to claim 14, **characterized in that**
    if a photon is not detected in the one second exposure period, the select circuit outputs a prescribed value, irrespectively of the time from the beginning of the other second exposure period until a photon is initially detected.

16. The photoelectric conversion device according to claim 1, wherein

a first board and a second board are stacked, the first board has the photoelectric conversion element, and the second board has the exposure control unit, the timing generation unit, and the measurement unit.

17. The photoelectric conversion device according to claim 8, wherein

a first board, a second board, and a third board are stacked, the first board has the photoelectric conversion element, and the second board has the waveform shaping circuit, the timing determination circuit, and the counter circuit, and the third board has the timing determination circuit and the counter circuit.

18. The photoelectric conversion device according to claim 17, wherein

a pulse signal generated by the timing generation unit to be inputted into the timing determination circuit provided on the second board and a pulse signal generated by the timing generation unit to be inputted into the timing determination circuit provided on the third board are different.

19. A photoelectric conversion system comprising:

the photoelectric conversion device according to any one of claims 1 to 18; and a signal processing unit that generates an image using a signal outputted by the photoelectric conversion device.

20. A moving body including the photoelectric conversion device according to any one of claims 1 to 18, wherein the moving body has a control unit that controls movement of the moving body using a signal outputted by the photoelectric conversion device.

# FIG. 1

# FIG. 2A

$$N_{ph} = (T_{acc}/T_{detect})$$

# FIG. 2B

NUMBER OF
INCIDENT PHOTONS
$$N_{ph} = (T_{acc}/T_{detect})$$

# FIG. 3A

# FIG. 3B

# FIG. 3C

NUMBER OF
INCIDENT PHOTONS
$N_{ph} = T_{acc} / T_{ave}$

OUTPUT (TIME)

$T_{ave}$

$N_{ph}$

INPUT
(NUMBER OF INCIDENT PHOTONS)

EP 4 738 872 A1

# FIG. 4

(A)

DETECTION PROBABILITY

HIGH ILLUMINANCE
MEDIUM ILLUMINANCE
LOW ILLUMINANCE

$f(t, \lambda) = \lambda e^{-\lambda t}$
$f(t, \lambda) = \lambda e^{-\lambda t}$

$*\lambda$: AVERAGE NUMBER OF EVENTS PER UNIT TIME

DETECTION TIME

(B)

CUMULATIVE DETECTION PROBABILITY

HIGH ILLUMINANCE
MEDIUM ILLUMINANCE
LOW ILLUMINANCE

1

$F(t, \lambda) = 1 - e^{-\lambda t}$

DETECTION TIME

(C)

BINNED CUMULATIVE DETECTION PROBABILITY

1

$F'(n, \lambda) = F(t_n, \lambda) - F(t_{n+1}, \lambda)$

HIGH ILLUMINANCE
MEDIUM ILLUMINANCE
LOW ILLUMINANCE

1    2    3    4    5    6  ••• DETECTION TIME

22

# FIG. 5A

E.G. OUTPUT OBTAINED FROM EXPONENTIAL DISTRIBUTION WHEN
EXPOSURE TIME IS 1000 AND UNIT TIME IS 1

| INPUT (NUMBER OF INCIDENT PHOTONS) $N_{ph}$ | 1 | 10 | 100 | 1000 |
|---|---|---|---|---|
| AVERAGE NUMBER $\lambda$ OF EVENTS PER UNIT TIME | 0.1% | 1% | 10% | 100% |
| OUTPUT E<br>(EXPECTED VALUE OF DETECTION TIME) | 264.6 | 100.5 | 10.5 | 1.6 |
| OUTPUT E'<br>(EXPECTED VALUE OF EXPOSURE TIME – DETECTION TIME) | 735.4 | 899.5 | 989.5 | 998.4 |

# FIG. 5B

# FIG. 5C

# FIG. 6

# FIG. 7

# FIG. 8

# FIG. 9

FIG. 10A

FIG. 10B

FIG. 10C

| P_ph | P_TCLK | P_sig |
|------|--------|-------|
| 0 | 0 | 0 |
| 0 | 1 | 0 |
| 1 | 0 | 0 |
| 1 | 1 | 1 |

27

# FIG. 11

# FIG. 12

EQUALLY SPACED PULSES

1 SUBFRAME

1 2 · · ·    · · ·

UNEQUALLY SPACED PULSES (QUASI-LOGARITHM)

1 2 · · ·

EP 4 738 872 A1

## FIG. 13A

CASE OF 16 EQUALLY SPACED PULSES WITHIN 1 SUBFRAME,
UNEQUALLY SPACED PULSES ARE QUASI-LOGARITHM (BASE 2) OF REAL TIME

EQUALLY SPACED PULSES

1  2  3  4  5  6  7  8  9  10  11  12  13  14  15  16

UNEQUALLY SPACED PULSES (QUASI-LOGARITHM)

1  2  3  4  5

## FIG. 13B

## FIG. 14A

# FIG. 14B

# FIG. 15

EP 4 738 872 A1

# FIG. 16

EP 4 738 872 A1

# FIG. 17

EP 4 738 872 A1

FIG. 18

1 SUBFRAME  2 SUBFRAME  3 SUBFRAME

P_PCLK

P_ph

P_TCLK

(WITH TIME CORRELATION FILTER)
P_sig

(WITHOUT TIME CORRELATION FILTER)
P_sig

# FIG. 19

FIG. 20

FIG. 21A

# FIG. 21B

# FIG. 22A

# FIG. 22B

# FIG. 23

# FIG. 24

## FIG. 25

| IMAGE ACQUISITION UNIT (403) | → | READOUT UNIT (404) | → | GAIN ADJUSTMENT UNIT (405) | → | NONLINEAR CORRECTION UNIT (406) | → | DEFECT CORRECTION UNIT (407) | → | DATA COMPRESSION UNIT (408) | → | STORAGE UNIT (409) |

TIMING ADJUSTMENT UNIT (402)

CONTROL UNIT (401)

# FIG. 26A

CONVENTIONAL METHOD
(Clocked recharge METHOD)

EXPOSURE PERIOD $\overleftrightarrow{\phantom{xxxxxxxxxxxxxxx}T\phantom{xxxxxxxxxxxxxxx}}$

$\Delta tr$

Recharge CLK

# FIG. 26B

WEIGHTED COUNT METHOD

EXPOSURE PERIOD $\overleftrightarrow{\phantom{xxxxxxxxxxxxxxx}T\phantom{xxxxxxxxxxxxxxx}}$

$\Delta tr$

Recharge CLK

$\Delta tw$

WEIGHTING COEFFICIENT

+N  +1

EP 4 738 872 A1

FIG. 27

43

# FIG. 28A

2300

| IMAGING DEVICE | ~2310 |
|---|---|
| IMAGE PROCESSING UNIT | ~2312 |
| DISPARITY ACQUISITION UNIT | ~2314 |
| DISTANCE MEASUREMENT UNIT | ~2316 |
| COLLISION DETERMINATION UNIT | ~2318 |

2320

VEHICLE INFORMATION ACQUISITION DEVICE

2330

CONTROL ECU

2340

WARNING DEVICE

# FIG. 28B

2300

2350

2320

VEHICLE INFORMATION ACQUISITION DEVICE

CONTROL ECU

WARNING DEVICE

2330

2340

# FIG. 29

# FIG. 30

## FIG. 31A

1600

1603

1601

1602

## FIG. 31B

1610

1612

1611

## INTERNATIONAL SEARCH REPORT

| International application No. |
| --- |
| **PCT/JP2024/023448** |

| A. | CLASSIFICATION OF SUBJECT MATTER |
| --- | --- |

*H04N 25/773*(2023.01)i; *H04N 25/70*(2023.01)i
FI: H04N25/773; H04N25/70

According to International Patent Classification (IPC) or to both national classification and IPC

| B. | FIELDS SEARCHED |
| --- | --- |

Minimum documentation searched (classification system followed by classification symbols)

H04N25/773; H04N25/70

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2020/179928 A1 (SONY SEMICONDUCTOR SOLUTIONS CORPORATION) 10 September 2020 (2020-09-10) <br> abstract | 1-20 |
| A | JP 2023-39400 A (CANON KABUSHIKI KAISHA) 20 March 2023 (2023-03-20) <br> fig. 6(b), 7(b), paragraphs [0049]-[0054] | 1-20 |
| A | JP 2023-61643 A (CANON KABUSHIKI KAISHA) 02 May 2023 (2023-05-02) <br> fig. 5, 8, paragraphs [0036], [0089] | 1-20 |
| A | JP 2023-66374 A (SAMSUNG ELECTRONICS CO., LTD.) 15 May 2023 (2023-05-15) <br> fig. 3, paragraphs [0040]-[0043] | 1-20 |

☐ Further documents are listed in the continuation of Box C.      ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **18 July 2024** | **30 July 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

## INTERNATIONAL SEARCH REPORT
### Information on patent family members

| International application No. |
|---|
| **PCT/JP2024/023448** |

| Patent document cited in search report | | | Publication date (day/month/year) | Patent family member(s) | | | Publication date (day/month/year) |
|---|---|---|---|---|---|---|---|
| WO | 2020/179928 | A1 | 10 September 2020 | US abstract | 2022/0155153 | A1 | |
| | | | | EP | 3936840 | A1 | |
| | | | | CN | 113424027 | A | |
| JP | 2023-39400 | A | 20 March 2023 | US fig. 6B, 7B, paragraphs [0072]-[0077] | 2023/0071218 | A1 | |
| | | | | DE | 102022122515 | A1 | |
| | | | | CN | 115802182 | A | |
| | | | | KR | 10-2023-0036971 | A | |
| JP | 2023-61643 | A | 02 May 2023 | WO fig. 5, 8, paragraphs [0037], [0090] | 2023/068074 | A1 | |
| JP | 2023-66374 | A | 15 May 2023 | US fig. 3, paragraphs [0069]-[0072] | 2023/0139967 | A1 | |
| | | | | EP | 4175311 | A1 | |
| | | | | KR | 10-2023-0061032 | A | |
| | | | | CN | 116055904 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020179928 A
- JP 2023108681 A
- JP 2024102830 A